# EUROPEAN PATENT SPECIFICATION

(11) **EP 3 933 461 B1**
(45) Date of publication and mention of the grant of the patent: **19.03.2025**
(21) Application number: 21181497.5
(22) Date of filing: 24.06.2021
(51) Int. Cl.: G02B 5/20, G02B 5/28

(54) **SPECTRAL FILTER, AND IMAGE SENSOR AND ELECTRONIC DEVICE INCLUDING THE SPECTRAL FILTER**
SPEKTRALFILTER UND BILDSENSOR UND ELEKTRONISCHE VORRICHTUNG MIT DEM SPEKTRALFILTER
FILTRE SPECTRAL ET CAPTEUR D'IMAGE ET DISPOSITIF ÉLECTRONIQUE COMPRENANT LE FILTRE SPECTRAL

(30) Priority: 02.07.2020 KR 20200081674; 11.05.2021 KR 20210060947
(43) Date of publication of application: 05.01.2022
(73) Proprietor: Samsung Electronics Co., Ltd., Suwon-si, Gyeonggi-do 16677 (KR)
(72) Inventor: KIM, Hyochul, 16678 Suwon-si, Gyeonggi-do (KR); ROH, Younggeun, 16678 Suwon-si, Gyeonggi-do (KR); PARK, Yeonsang, 16678 Suwon-si, Gyeonggi-do (KR); LEE, Jaesoong, 16678 Suwon-si, Gyeonggi-do (KR)
(74) Representative: Grünecker Patent- und Rechtsanwälte PartG mbB

(56) References cited:
- EP-A1- 2 432 019
- EP-A1- 2 738 810
- EP-A1- 3 258 493
- EP-A1- 3 557 625
- WO-A1-2018/043926
- WO-A1-2019/124113
- US-A1- 2009 159 785
- US-A1- 2013 077 958
- US-A1- 2013 163 005
- US-A1- 2019 025 482
- US-B1- 10 353 124

## Description

### BACKGROUND

### 1. Field

Example embodiments of the present disclosure relate to a spectral filter, and an image sensor and an electronic device, each including the spectral filter.

### 2. Description of the Related Art

Image sensors using spectral filters are one of important optical instruments in the field of optics. Image sensors according to the related art, including various optical devices, are bulky and heavy. Recently, according to the demand for miniaturization of image sensors, research has been conducted to simultaneously implement an integrated circuit and an optical element on a single semiconductor chip. US-A1-2013 163005 discloses an optical sensing device with a mult-cavity Fabry-Perot light filter.

### SUMMARY

One or more example embodiments provide a spectral filter, and an image sensor and an electronic device, each including the spectral filter.

Additional aspects will be set forth in part in the description, which follows and, in part, will be apparent from the description, or may be learned by practice of example embodiments.

According to an aspect of an example embodiment, there is provided a spectral filter including a first unit filter having a first center wavelength in a first wavelength range, and a second unit filter having a second center wavelength in a second wavelength range, wherein the first unit filter includes two first metal reflective layers provided spaced apart from each other and including a first metal, and a first cavity provided between the two first metal reflective layers, and wherein the second unit filter includes two second metal reflective layers provided spaced apart from each other and including a second metal different from the first metal, and a second cavity provided between the two second metal reflective layers.

The first unit filter and the second unit filter may be provided in one dimension or two dimensions on a plane.

The first center wavelength in the first wavelength range may be shorter than the second center wavelength in the second wavelength range.

The two first metal reflective layers may include one of aluminum (Al), silver (Ag), gold (Au), or titanium nitride (TiN), and the two second metal reflective layers may include one of copper (Cu), Ag, Au, or TiN that is different from the two first reflective metal layers.

The first unit filter may be included in a first filter array including a plurality of first unit filters having different center wavelengths, and the second unit filter may be included in a second filter array including a plurality of second unit filters having different center wavelengths.

The center wavelength of the first unit filter may be configured to be adjusted based on changing a thickness or an effective refractive index of the first cavity, and the center wavelength of the second unit filter may be configured to be adjusted based on changing a thickness or an effective refractive index of the second cavity.

The first unit filter may further include a first dielectric layer that is provided above the first cavity and a second dielectric layer provided below the first cavity, and the second unit filter may further include a third dielectric layer provided below the second cavity and a fourth dielectric layer provided above the second cavity.

Each of the first dielectric layer, a second dielectric layer, a third dielectric layer, and a fourth dielectric layer may include a single layer or multiple layers.

Each of the first dielectric layer, the second dielectric layer, the third dielectric layer, and the fourth dielectric layer may have a thickness ranging from 10 nm to 20000 nm.

At least one of a thickness or an effective refractive index of each of the first dielectric layer and the second dielectric layer may be adjusted based on the center wavelength of the first unit filter, and a thickness or an effective refractive index of each of the third dielectric layer and the fourth dielectric layer may be adjusted based on the center wavelength of the second unit filter.

The spectral filter may further include a plurality of microlenses provided on the first unit filter and the second unit filter.

The spectral filter may further include a color filter provided on a same plane as the first unit filter and the second unit filter.

The spectral filter may further include an additional filter provided on the first unit filter and the second unit filter, the additional filter being configured to transmit a preset wavelength band.

The additional filter may include a color filter or a broadband filter.

The first unit filter may include a plurality of first unit filters and the second unit filter includes a plurality of second unit filters, and a short wavelength absorption filter may be provided in some of the plurality of first unit filters and the plurality of second unit filters, and a long wavelength cut-off filter may be provided in other of the plurality of first unit filters and the plurality of second unit filters.

According to another aspect of an example embodiment, there is provided a spectral filter including at least one first unit filter having a first center wavelength in a first wavelength range, and at least one second unit filter having a second center wavelength in a second wavelength range, wherein the at least one first unit filter includes a plurality of metal reflective layers provided spaced apart from each other, and at least one first cavity provided between the plurality of metal reflective layers, and wherein the at least one second unit filter includes a plurality of Bragg reflective layers provided spaced apart from each other, and at least one second cavity provided between the plurality of Bragg reflective layers.

The at least one first unit filter and the at least one second unit filter may be provided in one dimension or two dimensions on a plane.

The first center wavelength of the at least one first unit filter may be configured to be adjusted based on changing a thickness or an effective refractive index of the at least one first cavity, and the second center wavelength of the at least one second unit filter may be configured to be adjusted based on changing a thickness or n effective refractive index of the at least one second cavity.

The spectral filter may further include a plurality of microlenses provided on the at least one first unit filter and the at least one second unit filter.

The spectral filter may further include a color filter provided on the plane.

The spectral filter may further include an additional filter provided on the at least one first unit filter and the at least one second unit filter, the additional filter being configured to transmit a preset wavelength band.

According to another aspect of an example embodiment, there is provided an image sensor including a spectral filter, and a pixel array configured to receive light transmitted through the spectral filter, wherein the spectral filter includes at least one first unit filter having a first center wavelength in a first wavelength range, and at least one second unit filter having a second center wavelength in a second wavelength range, wherein the at least one first unit filter includes a plurality of first metal reflective layers provided spaced apart from each other and including a first metal, and at least one first cavity provided between the plurality of first metal reflective layers, and wherein the at least one second unit filter includes a plurality of second metal reflective layers provided spaced apart from each other and including a second metal different from the first metal, and at least one second cavity provided between the plurality of second metal reflective layers.

The at least one first unit filter may further include a first dielectric layer provided below the at least one first cavity and a second dielectric layer provided above the at least one first cavity, and the at least one second unit filter may further include a third dielectric layer provided below the at least one second cavity and a fourth dielectric layer provided above the at least one second cavity.

The spectral filter may further include a plurality of microlenses provided on the at least one first unit filter and the at least one second unit filter.

The spectral filter may further include a color filter, and the at least one first unit filter, the at least one second unit filter, and the color filter may be provided on a same plane.

The spectral filter may further include an additional filter provided on the at least one first unit filter and the at least one second unit filter, the additional filter being configured to transmit a preset wavelength band.

The image sensor may further include a timing controller, a row decoder, and an output circuit.

An electronic device including the image sensor.

The electronic device may be one of a mobile phone, a smartphone, a tablet, a smart tablet, a digital camera, a camcorder, a notebook computer, a television, a smart television, a smart refrigerator, a security camera, a robot, or a medical camera.

According to another aspect of an example embodiment, there is provided an image sensor including a spectral filter, and a pixel array configured to receive light transmitted through the spectral filter, wherein the spectral filter includes at least one first unit filter having a first center wavelength in a first wavelength range, and at least one second unit filter having a second center wavelength in a second wavelength range, wherein the at least one first unit filter includes a plurality of metal reflective layers provided spaced apart from each other, and at least one first cavity provided between the plurality of metal reflective layers, and wherein the at least one second unit filter includes a plurality of Bragg reflective layers provided spaced apart from each other, and at least one second cavity provided between the plurality of Bragg reflective layers.

The spectral filter may further include a plurality of microlenses provided on the at least one first unit filter and the at least one second unit filter.

The spectral filter may further include a color filter, and the at least one first unit filter, the at least one second unit filter, and the color filter are provided on a same plane.

The spectral filter may further include an additional filter provided on the at least one first unit filter and the at least one second unit filter, the additional filter being configured to transmit a preset wavelength band.

The image sensor may further include a timing controller, a row decoder, and an output circuit.

An electronic device may include the image sensor.

The electronic device may be one of a mobile phone, a smartphone, a tablet, a smart tablet, a digital camera, a camcorder, a notebook computer, a television, a smart television, a smart refrigerator, a security camera, a robot, or a medical camera.

According to another aspect of an example embodiment, there is provided a spectral filter including a first unit filter having a first center wavelength in a first wavelength range, and a second unit filter having a second center wavelength in a second wavelength range, the second unit filter being provided adjacent to the first unit filter in a horizontal direction, wherein the first unit filter includes two first metal reflective layers provided spaced apart from each other in a vertical direction and including a first metal, and a first cavity provided between the two first metal reflective layers, and wherein the second unit filter includes two second metal reflective layers provided spaced apart from each other in the vertical direction and including a second metal different from the first metal, and a second cavity provided between the two second metal reflective layers.

### BRIEF DESCRIPTION OF THE DRAWINGS

The above and/or other aspects, features, and advantages of example embodiments of the disclosure will be more apparent from the following description taken in conjunction with the accompanying drawings, in which:
FIG. 1 is a block diagram of an image sensor according to an example embodiment;
FIG. 2 is a schematic cross-sectional view of a spectral filter taken along line II-II' of FIG. 1;
FIG. 3A is a cross-sectional view of a unit filter having a titanium oxide (TiO₂) cavity between copper (Cu) reflective layers;
FIG. 3B is a cross-sectional view of a unit filter having a TiO₂ dielectric layer in each of upper and lower portions of a structure illustrated in FIG. 3A;
FIG. 4 is a graph of transmittance spectrums of the unit filter of FIG. 3A and the unit filter of FIG. 3B;
FIG. 5 is a schematic cross-sectional view of a spectral filter according to another example embodiment;
FIG. 6 is a graph of a transmittance spectrum of the spectral filter of FIG. 5;
FIG. 7 is a schematic cross-sectional view of a spectral filter according to another example embodiment;
FIG. 8 is a graph of a transmittance spectrum of the spectral filter of FIG. 7;
FIG. 9 is a schematic cross-sectional view of a spectral filter according to another example embodiment;
FIG. 10 is a schematic cross-sectional view of a spectral filter according to another example embodiment;
FIG. 11 is a schematic cross-sectional view of a spectral filter according to another example embodiment;
FIG. 12 is a schematic cross-sectional view of a spectral filter according to another example embodiment;
FIG. 13 is a schematic cross-sectional view of a spectral filter according to another example embodiment;
FIG. 14 is a schematic cross-sectional view of a spectral filter according to another example embodiment;
FIG. 15 is a schematic cross-sectional view of a spectral filter according to another example embodiment;
FIG. 16 is a graph of a transmittance spectrum of the spectral filter of FIG. 15;
FIG. 17 is a schematic cross-sectional view of a spectral filter according to another example embodiment;
FIG. 18 is a schematic cross-sectional view of a spectral filter according to another example embodiment;
FIG. 19 is a schematic cross-sectional view of a spectral filter according to another example embodiment;
FIG. 20 is a schematic cross-sectional view of a broadband filter that is usable as the additional filter of FIG. 19, according to an example embodiment;
FIG. 21 is a schematic cross-sectional view of a broadband filter that is usable as the additional filter of FIG. 19, according to another example embodiment;
FIG. 22 is a schematic cross-sectional view of a spectral filter according to another example embodiment;
FIG. 23 is a plan view of an example of a spectral filter that is applicable to the image sensor of FIG. 1;
FIG. 24 is a plan view of another example of the spectral filter that is applicable to the image sensor of FIG. 1;
FIG. 25 is a plan view of another example of a spectral filter that is applicable to the image sensor of FIG. 1;
FIG. 26 is a schematic block diagram of an electronic device including an image sensor, according to an example embodiment;
FIG. 27 is a schematic block diagram of a camera module of FIG. 26; and
FIGS. 28, 29, 30, 31, 32, 33, 34, 35, 36, and 37 are views of various examples of an electronic device to which an image sensor is applied according to example embodiments.

### DETAILED DESCRIPTION

Reference will now be made in detail to example embodiments of which are illustrated in the accompanying drawings, wherein like reference numerals refer to like elements throughout. In this regard, the example embodiments may have different forms and should not be construed as being limited to the descriptions set forth herein. Accordingly, the example embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

The size of each constituent element illustrated in the drawings may be exaggerated for convenience of explanation and clarity. In the above, although embodiments have been described, these are merely exemplary, and those skilled in the art to which the present disclosure pertains could make various modifications and changes from these descriptions.

When a constituent element is disposed "above" or "on" to another constituent element, the constituent element may include not only an element directly contacting on the upper/lower/left/right sides of the other constituent element, but also an element disposed above/under/left/right the other constituent element in a noncontact manner. As used herein, the singular forms "a," "an" and "the" are intended to include the plural forms as well, unless the context clearly indicates otherwise. It will be further understood that the terms "comprises" and/or "comprising" used herein specify the presence of stated features or components, but do not preclude the presence or addition of one or more other features or components.

The use of the terms "a" and "an" and "the" and similar referents in the context of describing the disclosure are to be construed to cover both the singular and the plural. Also, the steps of all methods described herein can be performed in any suitable order unless otherwise indicated herein or otherwise clearly contradicted by context. The disclosure is not limited to the described order of the steps.

Furthermore, terms such as "to portion," "to unit," "to module," and "to block" stated in the specification may signify a unit to process at least one function or operation and the unit may be embodied by hardware, software, or a combination of hardware and software.

Furthermore, the connecting lines, or connectors shown in the various figures presented are intended to represent functional relationships and/or physical or logical couplings between the various elements.

The use of any and all examples, or language (e.g., "such as") provided herein, is intended merely to better illuminate the disclosure and does not pose a limitation on the scope of the disclosure unless otherwise claimed.

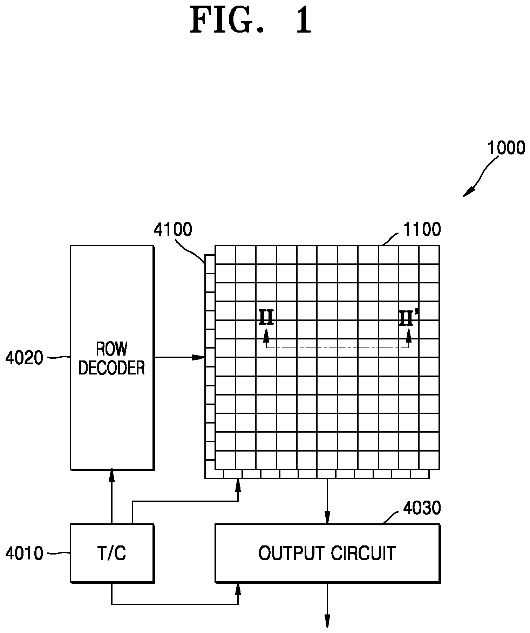

FIG. 1 is a schematic block diagram of an image sensor 1000 according to an example embodiment.

Referring to FIG. 1, the image sensor 1000 may include a spectral filter 1100, a pixel array 4100, a timing controller 4010, a row decoder 4020, and an output circuit 4030. The image sensor 1000 may include a charge coupled device (CCD) image sensor or a complementary metal oxide semiconductor (CMOS) image sensor, but embodiments are not limited thereto.

The spectral filter 1100 may include a plurality of unit filters that transmit light of different wavelength ranges and are arranged in two dimensions. The pixel array 4100 may include a plurality of pixels that detect light of different wavelengths that are transmitted through the unit filters. For example, the pixel array 4100 may include pixels arranged in two dimensions along a plurality of rows and columns. The row decoder 4020 may select one of the rows of the pixel array 4100 in response to a row address signal output from the timing controller 4010. The output circuit 4030 may output a light detection signal in units of columns from the pixels arranged in a selected row. To this end, the output circuit 4030 may include a column decoder and an analog to digital converter (ADC). For example, the output circuit 4030 may include a plurality of ADCs arranged for each column between the column decoder and the pixel array 4100, or a single ADC arranged at an output end of the column decoder. The timing controller 4010, the row decoder 4020, and the output circuit 4030 may be implemented by a single chip or separate chips. A processor for processing an image signal output through the output circuit 4030 may be implemented by a single chip with the timing controller 4010, the row decoder 4020, and the output circuit 4030. The pixel array 4100 may include a plurality of pixels that detect light of different wavelengths, and the pixels may be arranged in various methods.

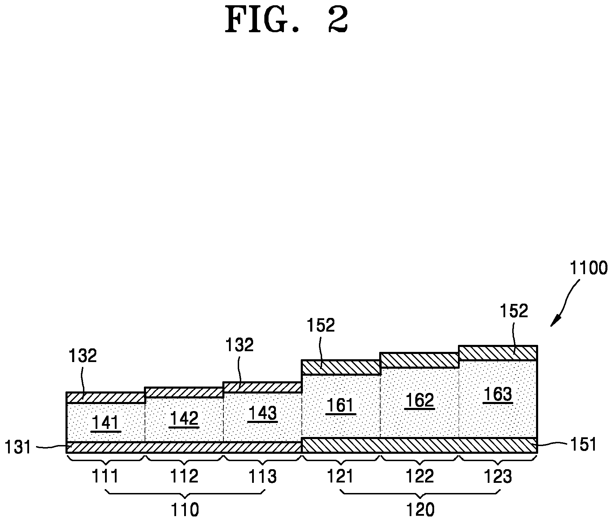

In the following description, the spectral filter 1100 of the image sensor 1000 is described in detail. FIG. 2 is a schematic cross-sectional view of a spectral filter taken along line II-II' of FIG. 1.

Referring to FIGS. 1 and 2, the spectral filter 1100 may include a plurality of unit filters arranged in one dimension or two dimensions. FIG. 2 illustrates an example of cross-sections of six unit filters 111, 112, 113, 121, 122, and 123.

The spectral filter 1100 may include a first filter array 110 and a second filter array 120 arranged on a plane. Although the first and second filter arrays 110 and 120 may be arranged on substantially the same plane, embodiments are not limited thereto. The first filter array 110 may include at least one unit filter having a center wavelength in a first wavelength range. The first wavelength range may be a range of, for example, about 250 nm to about 600 nm. However, this is merely exemplary, and the first wavelength range may also be various wavelength ranges according to a design condition. FIG. 2 illustrates an example in which the first filter array 110 includes a first unit filter 111, a second unit filter 112, and a third unit filter 113.

The second filter array 120 may include at least one unit filter having a center wavelength in a second wavelength range. The second wavelength range may be greater than the first wavelength range. For example, the second wavelength range may be a range of about 600 nm to about 1100 nm. However, this is merely exemplary, and the second wavelength range may also be various wavelength ranges according to a design condition. FIG. 2 illustrates a case in which the second filter array 120 includes a fourth unit filter 121, a fifth unit filter 122, and a sixth unit filter 123.

FIG. 2 illustrates a case in which each of the first and second filter arrays 110 and 120 includes three unit filters 111, 112, and 113, and 121, 122, and 123, however embodiments are not limited thereto, and the number of unit filters constituting each of the first and second filter arrays 110 and 120 may be variously changed.

Each of the first, second, and third unit filters 111, 112, and 113 constituting the first filter array 110 may transmit light having a specific center wavelength in the first wavelength range, and have a Fabry-Perot structure in which cavities 141, 142, and 143 are provided adjacent to each other in a horizontal direction and between two first metal reflective layers 131 and 132 spaced apart from each other in a vertical direction.

When light is incident on the cavities 141, 142, and 143 by transmitting through the first metal reflective layers 131 and 132, the light may reciprocate between the first metal reflective layers 131 and 132 inside the cavities 141, 142, and 143, during which a constructive interference and a destructive interference occur. Light having a specific center wavelength and satisfying a constructive interference condition may exit to the outside of each of the first, second, and third unit filters 111, 112, and 113. The wavelength band and the center wavelength of the light passing through the first, second, and third unit filters 111, 112, and 113 may be determined according to a reflection band of the first metal reflective layers 131 and 132 and the characteristics, for example, a thickness and a refractive index, of each of the cavities 141, 142, and 143.

The first metal reflective layers 131 and 132 may include a first metal capable of reflecting light in the first wavelength range. For example, the first metal may include aluminum (Al), silver (Ag), gold (Au), titanium nitride (TiN), and the like. However, embodiments are not limited thereto. The first metal reflective layers 131 and 132 may have a thickness of, for example, tens of nanometers, however embodiments are not limited thereto. For example, the first metal reflective layers 131 and 132 may have a thickness of about 10 nm to about 30 nm.

The cavities 141, 142, and 143 provided between the first metal reflective layers 131 and 132, as resonance layers, may include a dielectric material having a certain refractive index. For example, an average refractive index of the cavity with a single transmission peak may range from 1.4 to 3.5, and the thickness may range from around 20 nm to 500 nm. For example, when the center wavelength may range from around 350 nm to 600 nm, the cavity thickness may range around 20 nm to 150 nm with the refractive index being between 1.4 and 3.5. When the center wavelength ranges from around 600 nm to 1000 nm, the cavity thickness may range from around 80 nm to 250 nm with the refractive index being between 1.4 and 3.5. In a multi-mode cavity, a thickness of the cavity may be increased.

For example, the cavities 141, 142, and 143 may include silicon, a silicon oxide, a silicon nitride, a hafnium oxide, or a titanium oxide, or a combination of these materials. For example, the cavities 141, 142, and 143 may include a TiO₂/SiN multilayer or patterned structures of TiO₂/SiO₂. However, embodiments are not limited thereto.

The first, second, and third unit filters 111, 112, and 113 may have different center wavelengths in the first wavelength range. To this end, the first, second, and third unit filters 111, 112, and 113 may respectively include the first, second, and third cavities 141, 142, and 143 having different thicknesses. FIG. 2 illustrates an example in which the second cavity 142 is thicker than the first cavity 141, and the third cavity 143 is thicker than the second cavity 142. In this case, among the first, second, and third unit filters 111, 112, and 113, the third unit filter 113 may have the longest center wavelength, and the first unit filter 111 may have the shortest center wavelength. Furthermore, some unit filters may have a plurality of center wavelengths corresponding to the thickness of a cavity.

Each of the fourth, fifth, and sixth unit filters 121, 122, and 123 constituting the second filter array 120 may transmit light having a specific center wavelength in the second wavelength range, and may have a Fabry-Perot structure in which cavities 161, 162, and 163 are provided between two second metal reflective layers 151 and 152 spaced apart from each other. The wavelength band and the center wavelength of the light passing through the fourth, fifth, and sixth unit filters 121, 122, and 123 may be determined according to a reflection band of the second metal reflective layers 151 and 152 and the characteristics of the cavities 161, 162, and 163.

The second metal reflective layers 151 and 152 may include a second metal capable of reflecting light in the second wavelength range. For example, the second metal may include copper (Cu), Ag, Au, TiN**,** and the like. However, embodiments are not limited thereto. The second metal reflective layer may have a thickness of, for example, tens of nanometers, but embodiments are not limited thereto. For example, the second metal reflective layers 151 and 152 may have a thickness of about 40 nm to about 50 nm.

The second metal constituting the second metal reflective layers 151 and 152 may be a metal different from the first metal constituting the above-described first metal reflective layers 131 and 132. For example, when the first metal reflective layers 131 and 132 include Al, the second metal reflective layers 151 and 152 may include Cu. Furthermore, for example, when the first metal reflective layers 131 and 132 include Al, the second metal reflective layers 151 and 152 may include Ag. Furthermore, for example, when the first metal reflective layers 131 and 132 include Ag, the second metal reflective layers 151 and 152 may include Cu.

The cavities 161, 162, and 163 provided between the second metal reflective layers 151 and 152, as resonance layers, may include a dielectric material having a certain refractive index. For example, the cavities 161, 162, and 163 may include silicon, a silicon oxide, a silicon nitride, a hafnium oxide, or a titanium oxide.

The cavities 161, 162, and 163 provided between the second metal reflective layers 151 and 152 may include the same material as the cavities 141, 142, and 143 provided between the first metal reflective layers 131 and 132. In this case, the thicknesses of the cavities 161, 162, and 163 provided between the second metal reflective layers 151 and 152 may be different from the thicknesses of the cavities 141, 142, and 143 provided between the first metal reflective layers 131 and 132. The cavities 161, 162, and 163 provided between the second metal reflective layers 151 and 152 may include a material different from the cavities 141, 142, and 143 provided between the first metal reflective layers 131 and 132. The thickness of the cavities may vary depending on the material of the metal reflective layers provided on the cavities. A thickness of the cavity may correspond to a thickness of a skin depth of the material of the metal reflective layers. For example, a thickness of a cavity provided between Al metal reflectors may be greater than a cavity provided between Cu metal reflectors for a unit filter having a same center wavelength.

The fourth, fifth, and sixth unit filters 121, 122, and 123 may have different center wavelengths in the second wavelength range. To this end, the fourth, fifth, and sixth unit filters 121, 122, and 123 may include the fourth, fifth, and sixth cavities 161, 162, and 163 having different thicknesses. FIG. 2 illustrates a case in which the fifth cavity 162 is thicker than the fourth cavity 161, and the sixth cavity 163 is thicker than the fifth cavity 162. In this case, among the fourth, fifth, and sixth unit filters 121, 122, and 123, the sixth unit filter 123 may have the longest center wavelength, and the fourth unit filter 121 may have the shortest center wavelength. Furthermore, some unit filters may have a plurality of center wavelengths according to the thickness of a cavity.

As described above, as the first filter array 110 in which the cavities 141, 142, and 143 are provided between the first metal reflective layers 131 and 132 and the second filter array 120 in which the cavities 161, 162, and 163 are provided between the second metal reflective layers 151 and 152 are arranged on a plane, a spectral filter having the characteristics of a broadband including the first wavelength range and the second wavelength range, for example, a wavelength range from ultraviolet to near infrared, may be implemented.

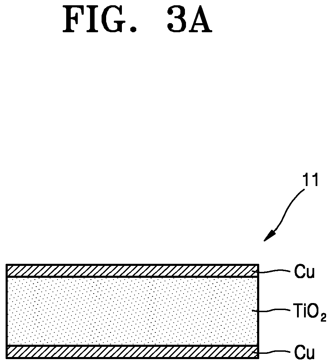

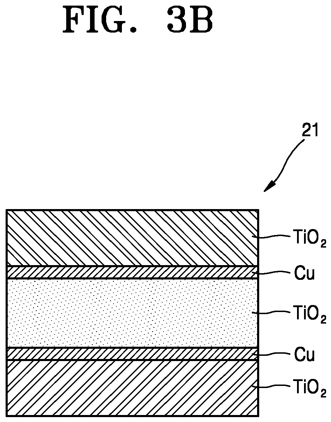

FIG. 3A is a cross-sectional view of a unit filter 11 having a TiO₂ cavity between Cu reflective layers. FIG. 3B is a cross-sectional view of a unit filter 21 having a TiO₂ dielectric layer in each of upper and lower portions of a structure of FIG. 3A.

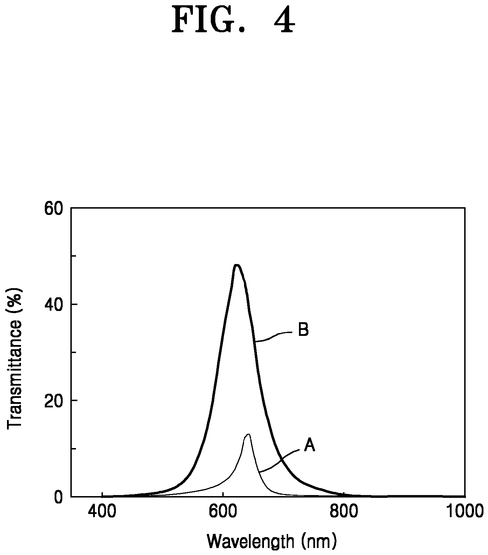

FIG. 4 is a graph of transmittance spectrums of the unit filter 11 of FIG. 3A and the unit filter 21 of FIG. 3B. In FIG. 4, "A" denotes a transmittance spectrum of the unit filter 11 of FIG. 3A, and "B" denotes a transmittance spectrum of the unit filter 21 of FIG. 3B. Referring to FIG. 4, it may be seen that the unit filter 21 of FIG. 3B has a higher transmittance than the unit filter 11 of FIG. 3A.

As such, the unit filter 21 with an improved transmittance may be implemented by further providing the TiO₂ dielectric layer in each of the upper and lower portions of the structure having the TiO₂ cavity between the Cu reflective layers. The thickness of the TiO₂ dielectric layer may be adjusted according to the center wavelength of the unit filter 21.

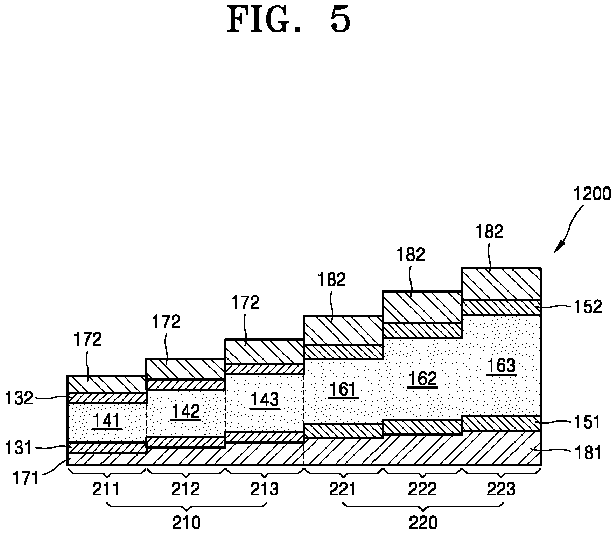

FIG. 5 is a schematic cross-sectional view of a spectral filter 1200 according to another example embodiment.

Referring to FIG. 5, a first filter array 210 may include a first unit filter 211, a second unit filter 212, and a third unit filter 213 having center wavelengths in the first wavelength range. A second filter array 220 may include fourth unit filter 221, a fifth unit filter 222, and a sixth unit filter 223 having center wavelengths in the second wavelength range.

Each of the first, second, and third unit filters 211, 212, and 213 constituting the first filter array 210 may include the two first metal reflective layers 131 and 132 arranged spaced apart from each other, the cavities 141, 142, and 143 provided between the first metal reflective layers 131 and 132, and first dielectric layer 171 and a second dielectric layer 172 respectively provided below and above each of the cavities 141, 142, and 143. The first, second, and third unit filters 211, 212, and 213 may include the first, second, and third cavities 141, 142, and 143 having different thicknesses, to have different center wavelengths in the first wavelength range. The first metal reflective layers 131 and 132 and the first, second, and third cavities 141, 142, and 143 are similar to those described above with respect to FIG. 2.

The first dielectric layer 171 may be provided below the first metal layer 131, and the second dielectric layer 172 may be provided above the first metal layer 132. The first and second dielectric layers 171 and 172 may improve transmittance of the first, second, and third unit filters 211, 212, and 213. The first and second dielectric layers 171 and 172 may have a single layer structure. Each of the first and second dielectric layers 171 and 172 may include, for example, a titanium oxide, a silicon nitride, a hafnium oxide, a silicon oxide, a high index polymer, and the like. However, embodiments are not limited thereto.

The thicknesses of the first and second dielectric layers 171 and 172 may be changed according to the center wavelengths of the first, second, and third unit filters 211, 212, and 213. FIG. 5 illustrates a case in which the thicknesses of the first and second dielectric layers 171 and 172 increase as the center wavelengths of the first, second, and third unit filters 211, 212, and 213 increase. Although the thickness of each of the first and second dielectric layers 171 and 172 may be about 10 nm to about 20000 nm, embodiments are not limited thereto. For example, the thickness of each of the first and second dielectric layers 171 and 172 may range from about 10 nm to 2000 nm.

Each of the fourth, fifth, and sixth unit filters 221, 222, and 223 constituting the second filter array 220 may include the two second metal reflective layers 151 and 152 arranged spaced apart from each other, the cavities 161, 162, and 163 provided between the second metal reflective layers 151 and 152, and third dielectric layer 181 and a fourth dielectric layer 182 respectively provided below and above each of the cavities 161, 162, and 163. The fourth, fifth, and sixth unit filters 221, 222, and 223 may include the fourth, fifth, and sixth cavities 161, 162, and 163 having different thicknesses, to have different center wavelengths in the second wavelength range. The second metal reflective layers 151 and 152 and the fourth, fifth, and sixth cavities 161, 162, and 163 are as described above.

The third dielectric layer 181 may be provided below the second metal layer 151, and the fourth dielectric layer 182 may be provided above the second metal layer 152. The third and fourth dielectric layers 181 and 182 may be to improve transmittance of the fourth, fifth, and sixth unit filters 221, 222, and 223. The third and fourth dielectric layers 181 and 182 may have a single layer structure. Each of the third and fourth dielectric layers 181 and 182 may include, for example, a titanium oxide, a silicon nitride, a hafnium oxide, a silicon oxide, a high index polymer, and the like, like the above-described first and second dielectric layers 171 and 172, but embodiments are not limited thereto.

The thicknesses of the third and fourth dielectric layers 181 and 182 may be changed according to the center wavelengths of the fourth, fifth, and sixth unit filters 221, 222, and 223. FIG. 5 illustrates a case in which the thicknesses of the third and fourth dielectric layers 181 and 182 increase as the center wavelengths of the fourth, fifth, and sixth unit filters 221, 222, and 223 increase. Although the thickness of each of the third and fourth dielectric layers 181 and 182 may be about 10 nm to about 20000 nm, embodiments are not limited thereto. For example, the thickness of each of the third and fourth dielectric layers 181 and 182 may range from about 10 nm to 2000 nm

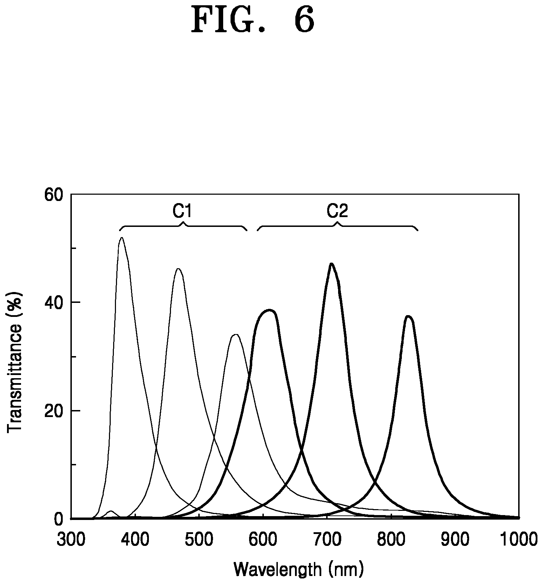

FIG. 6 is a graph of a transmittance spectrum of the spectral filter 1200 of FIG. 5. The first metal reflective layers 131 and 132 include Al, and the second metal reflective layers 151 and 152 include Cu, and the first to sixth cavities 141, 142, 143, 161, 162, and 163 include TiO₂. The first, second, third, and fourth dielectric layers 171, 172, 181, and 182 all include TiO₂. In FIG. 6, "C1" denotes a transmittance spectrum of the first filter array 210, and "C2" denotes a transmittance spectrum of the second filter array 220.

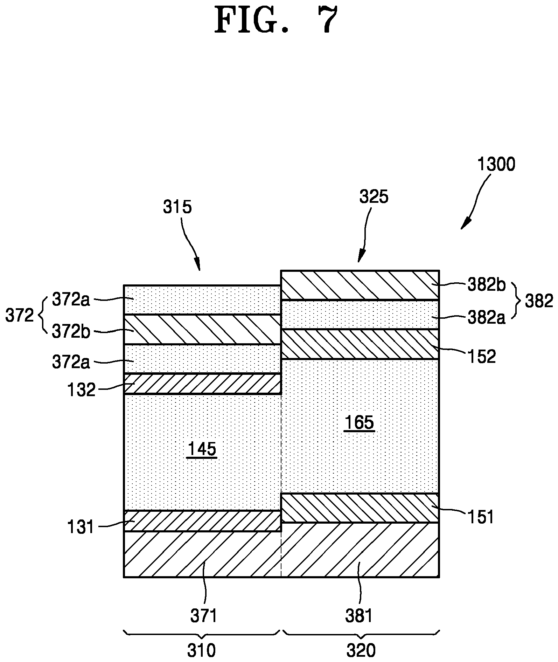

FIG. 7 is a schematic cross-sectional view of a spectral filter 1300 according to another example embodiment.

Referring to FIG. 7, a first filter array 310 may include at least one unit filter having a center wavelength in a first wavelength range. A second filter array 320 may include at least one unit filter having a center wavelength in a second wavelength range.

FIG. 7 illustrates a case in which, for convenience of explanation, the first filter array 310 includes one unit filter (a first unit filter 315), and the second filter array 320 includes one unit filter (a second unit filter 325). When each of the first and second filter arrays 310 and 320 includes a plurality of unit filters, the unit filters may include cavities of different thicknesses.

The first unit filter 315 constituting the first filter array 310 may include the two first metal reflective layers 131 and 132 arranged spaced apart from each other, a first cavity 145 provided between the first metal reflective layers 131 and 132, and first and second dielectric layers 371 and 372 respectively provided below and above the first cavity 145.

The first dielectric layer 371 may be provided below the first metal layer 131, and the second dielectric layer 372 may be provided above the first metal layer 132. Each of the first and second dielectric layers 371 and 372 may include a titanium oxide, a silicon nitride, a hafnium oxide, a silicon oxide, a high index polymer, and the like, but embodiments are not limited thereto.

The first dielectric layer 371 may have a single layer structure. However, embodiments are not limited thereto, and the first dielectric layer 371 may have a multi-layer structure. The second dielectric layer 372 may have a multi-layer structure. For example, the second dielectric layer 372 may have a structure in which the first and second material layers 372a and 372b different from each other are alternately stacked. The thickness and number of material layers constituting the second dielectric layer 372 may be adjusted according to the center wavelength of the first unit filter 315. The second dielectric layer 372 may include three or more material layers different from each other.

The second unit filter 325 constituting the second filter array 320 may include the second metal reflective layers 151 and 152 arranged spaced apart from each other, a second cavity 165 provided between the second metal reflective layers 151 and 152, and third and fourth dielectric layers 381 and 382 respectively provided below and above the second cavity 165.

The third dielectric layer 381 may be provided below the second metal layer 151, and the fourth dielectric layer 382 may be provided above the second metal layer 152. The third and fourth dielectric layers 381 and 382 may include a titanium oxide, a silicon nitride, a hafnium oxide, a silicon oxide, a high index polymer, and the like, like the first and second dielectric layers 371 and 372, but embodiments are not limited thereto.

The third dielectric layer 381 may have a single layer structure or a multi-layer structure. The fourth dielectric layer 382 may have a multi-layer structure. For example, the fourth dielectric layer 382 may have a structure in which first and second material layers 382a and 382b different from each other are alternately stacked. The thickness and number of material layers constituting the fourth dielectric layer 382 may be adjusted according to the center wavelength of the second unit filter 325. The fourth dielectric layer 382 may include three or more material layers different from one another.

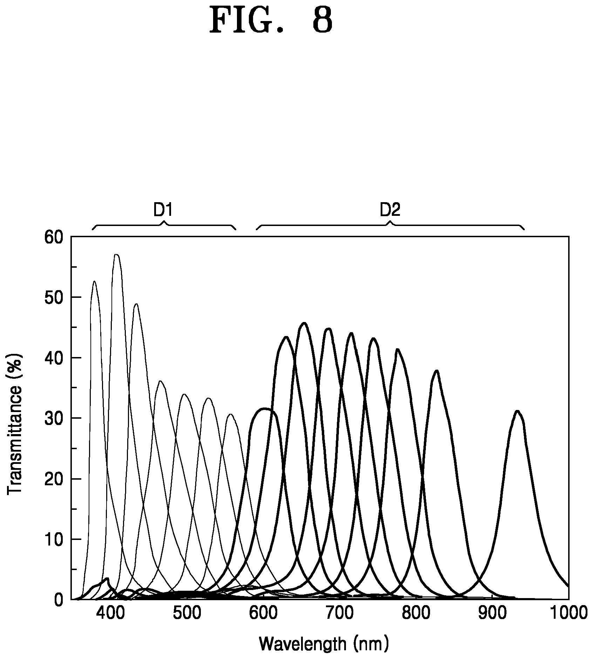

FIG. 8 is a graph of a transmittance spectrum of the spectral filter 1300 of FIG. 7. FIG. 8 illustrates a transmittance spectrum in a case in which, in the spectral filter 1300 of FIG. 7, the first filter array 310 includes seven unit filters having different center wavelengths, and the second filter array 320 includes nine unit filters having different center wavelengths.

The first metal reflective layers 131 and 132 include Al, and the second metal reflective layers 151 and 152 include Cu, and each of the first and second cavities 145 and 165 include a multi-layer film of TiO₂ and SiN. Each of the first and third dielectric layers 371 and 381 include SiN, and each of the second and fourth dielectric layers 372 and 382 may include a multi-layer film of TiO₂ and SiN. In FIG. 8, "D1" denotes a transmittance spectrum of the first filter array 310, and "D2" denotes a transmittance spectrum of the second filter array 320. Referring to FIG. 8, it may be seen that the spectral filter 1300 implements broadband characteristics and high transmittance.

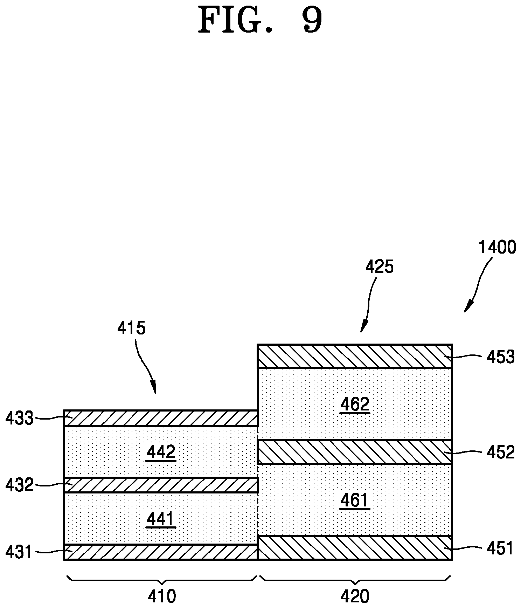

FIG. 9 is a schematic cross-sectional view of a spectral filter 1400 according to another example embodiment. FIG. 9 illustrates an example in which, for convenience of explanation, a first filter array 410 includes one unit filter (a first unit filter 415), and a second filter array 420 includes one unit filter (a second unit filter 425).

The first unit filter 415 constituting the first filter array 410 may include three first metal reflective layers 431, 432, and 433 arranged spaced apart from one another, and two first cavities 441 and 442 provided between the first metal reflective layers 431, 432, and 433.

Each of the first metal reflective layers 431, 432, and 433 may include a first metal capable of reflecting light in a first wavelength range. Each of the first cavities 441 and 442 may include, for example, a dielectric material such as silicon, a silicon oxide, a silicon nitride, a hafnium oxide, a titanium oxide, and the like.

The second unit filter 425 constituting the second filter array 420 may include three second metal reflective layers 451, 452, and 453 arranged spaced apart from one another, and two second cavities 461 and 462 provided between the second metal reflective layers 451, 452, and 453.

Each of the second metal reflective layers 451, 452, and 453 may include a second metal capable of reflecting light in a second wavelength range. Each of the second cavities 461 and 462 may include, for example, a dielectric material such as silicon, a silicon oxide, a silicon nitride, a hafnium oxide, a titanium oxide, and the like.

Although each of the first and second unit filters 415 and 425 is as described above as including two cavities (441 and 442, and 461 and 462), each of the first and second unit filters 415 and 425 may include three or more cavities. Furthermore, although both of the first and second unit filters 415 and 425 are as described above as including a multi-cavity structure, one of the first and second unit filters 415 and 425 may have a single cavity structure and the other may have a multi-cavity structure.

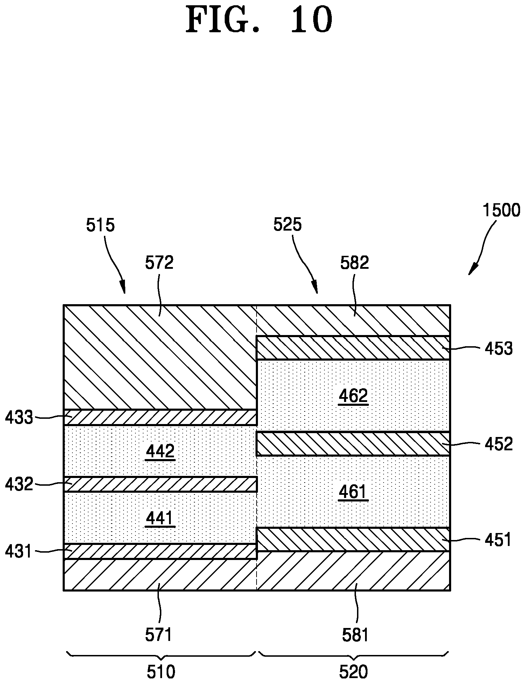

FIG. 10 is a schematic cross-sectional view of a spectral filter 1500 according to another example embodiment. FIG. 10 illustrates an example in which, for convenience of explanation, a first filter array 510 includes one unit filter (a first unit filter 515), and a second filter array 520 includes one unit filter (a second unit filter 525).

Referring to FIG. 10, the first unit filter 515 constituting the first filter array 510 may include the first metal reflective layers 431, 432, and 433 arranged spaced apart from one another, the first cavities 441 and 442 provided between the first metal reflective layers 431, 432, and 433, and first and second dielectric layers 571 and 572 respectively provided below and above the first cavities 441 and 442. The first metal reflective layers 431, 432, and 433 and the first cavities 441 and 442 are as described above.

The first dielectric layer 571 may be provided below the first metal reflective layer 431, and the second dielectric layer 572 may be provided above the first metal reflective layer 433. The first and second dielectric layers 571 and 572 are to improve transmittance, and may have a single layer or a multi-layer structure. Although each of the first and second dielectric layers 571 and 572 may include, for example, a titanium oxide, a silicon nitride, a hafnium oxide, a silicon oxide, a high index polymer, and the like, embodiments are not limited thereto.

The second unit filter 525 constituting the second filter array 520 may include the second metal reflective layers 451, 452, and 453 arranged spaced apart from one another, the second cavities 461 and 462 provided between the second metal reflective layers 451, 452, and 453, and third and fourth dielectric layers 581 and 582 respectively provided below and above the second cavities 461 and 462. The second metal reflective layers 451, 452, and 453 and the second cavities 461 and 462 are as described above.

The third dielectric layer 581 may be provided below the second metal reflective layer 451, and the fourth dielectric layer 582 may be provided above the second metal reflective layer 453. Although each of the third and fourth dielectric layers 581 and 582 may have a single layer or a multi-layer structure, and include, for example, a titanium oxide, a silicon nitride, a hafnium oxide, a silicon oxide, a high index polymer, and the like, embodiments are not limited thereto.

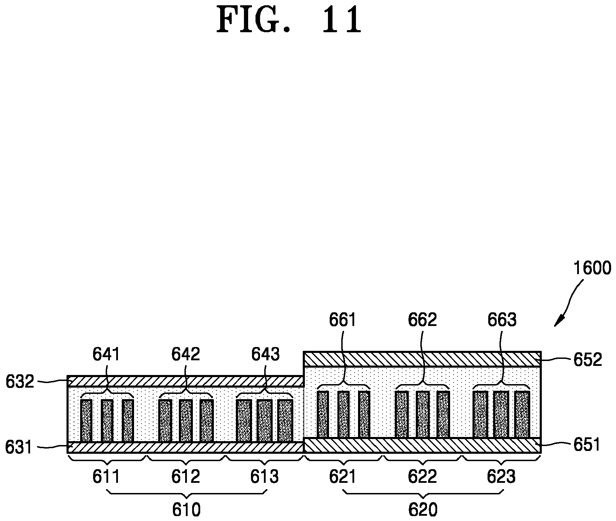

FIG. 11 is a schematic cross-sectional view of a spectral filter 1600 according to another example embodiment.

Referring to FIG. 11, a first filter array 610 may include at least one unit filter having a center wavelength in a first wavelength range, and a second filter array 620 may include at least one unit filter having a center wavelength in a second wavelength range. FIG. 11 illustrates an example in which the first filter array 610 includes first, second, and third unit filters 611, 612, and 613, and the second filter array 620 includes fourth, fifth, and sixth unit filters 621, and 622, and 623.

Each of the first, second, and third unit filters 611, 612, and 613 constituting the first filter array 610 may include two first metal reflective layers 631 and 632 arranged spaced apart from each other and the first, second, and third cavities 641, 642, and 643 provided between the first metal reflective layers 631 and 632. As the first metal reflective layers 631 and 632 are as described above, descriptions thereof are omitted.

The first, second, and third unit filters 611, 612, and 613 may have different center wavelengths in the first wavelength range. To this end, the first, second, and third unit filters 611, 612, and 613 may respectively include the first, second, and third cavities 641, 642, and 643 having different effective refractive indexes. Each of the first, second, and third cavities 641, 642, and 643 may include a first material layer and at least one second material layer arranged inside the first material layer and having a refractive index different from the first material layer.

FIG. 11 illustrates a case in which each of the first, second, and third cavities 641, 642, and 643 includes the first material layer and a plurality of second material layers arranged inside the first material layer parallel to each other and perpendicular to the first metal reflective layer 631. Each of the first and second material layers may include, for example, silicon, a silicon oxide, a silicon nitride or a titanium oxide, and the like. The first material layer and the second material layer may have a relatively high contrast to control the effective refractive index of the cavities. For example, the first material layer may include a silicon oxide, and the second material layer may include a titanium oxide. However, embodiments are not limited thereto.

In the first, second, and third cavities 641, 642, and 643, an effective refractive index may be changed by adjusting the width of the second material layer. FIG. 11 illustrates a case in which the second material layer has a width gradually increasing from the first cavity 641 to the third cavity 643. For example, pitches of the second material layer may range from about 100 nm to 300 nm, and widths of the second material layer may be around 0, 20, 40, 60, 80, and 100% of the pitches depending on the center wavelength of the unit filter. In this case, among the first, second, and third cavities 641, 642, and 643, the third cavity 643 may have the highest effective refractive index, and the first cavity 641 may have the lowest effective refractive index. Among the first, second, and third unit filters 611, 612, and 613, the third unit filter 613 may have the longest center wavelength, and the first unit filter 611 may have the shortest center wavelength. Furthermore, some unit filters may have a plurality of center wavelengths according to the thickness or effective refractive index of a cavity.

Although an example of a plurality of second material layers being arranged perpendicular to the first metal reflective layer 631 is described above, embodiments are not limited thereto, and the second material layers may be arranged parallel to the first metal reflective layer 631.

Each of the fourth, fifth, and sixth unit filters 621, and 622, and 623 constituting the second filter array 620 may include the second metal reflective layers 651 and 652 arranged spaced apart from each other and fourth, fifth, and sixth cavities 661, 662, and 663 provided between the second metal reflective layers 651 and 652. As the second metal reflective layers 651 and 652 are as described above, descriptions thereof are omitted.

The fourth, fifth, and sixth unit filters 621, and 622, and 623 may have different center wavelengths in the second wavelength range. To this end, the fourth, fifth, and sixth unit filters 621, and 622, and 623 may respectively include the fourth, fifth, and sixth cavities 661, 662, and 663 having different effective refractive indexes. Each of the fourth, fifth, and sixth cavities 661, 662, and 663 may include a first material layer and at least one second material layer arranged inside the first material layer and having a different refractive index from the first material layer.

FIG. 11 illustrates a case in which each of the fourth, fifth, and sixth cavities 661, 662, and 663 includes the first material layer and a plurality of second material layers arranged inside the first material layer parallel to each other and perpendicular to the second metal reflective layer 651. Each of the first and second material layers may include, for example, silicon, a silicon oxide, a silicon nitride or a titanium oxide, and the like.

In the fourth, fifth, and sixth cavities 661, 662, and 663, an effective refractive index may be changed by adjusting the width of the second material layer. FIG. 11 illustrates a case in which the second material layer has a width gradually increasing from the fourth cavity 661 to the sixth cavity 663. In this case, among the fourth, fifth, and sixth cavities 661, 662, and 663, the sixth cavity 663 may have the highest effective refractive index, and the fourth cavity 661 may have the lowest effective refractive index. Among the fourth, fifth, and sixth unit filters 621, and 622, and 623, the sixth unit filter 623 may have the longest center wavelength, and the fourth unit filter 621 may have the shortest center wavelength. Furthermore, some unit filters may have a plurality of center wavelengths according to the thickness or effective refractive index of a cavity.

A case in which both of the first filter array 610 and the second filter array 620 have a single cavity structure is described as an example. However, both of the first filter array 610 and the second filter array 620 may have a multi-cavity structure. Furthermore, one of the first filter array 610 and the second filter array 620 may have a single cavity structure, and the other may have a multi-cavity structure.

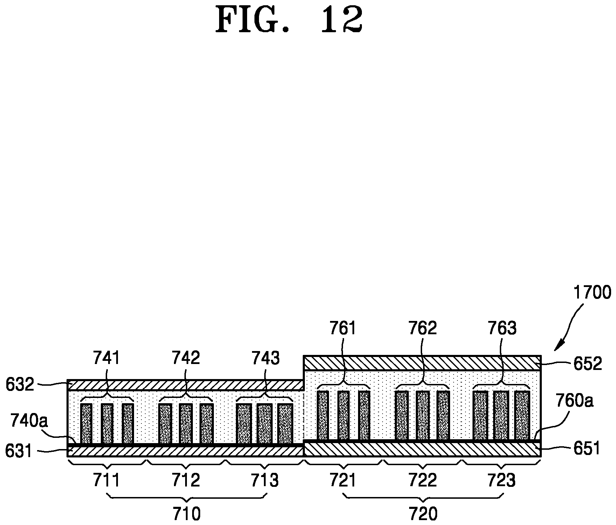

FIG. 12 is a schematic cross-sectional view of a spectral filter 1700 according to another example embodiment. The spectral filter 1700 of FIG. 12 is the same as the spectral filter 1600 of FIG. 11, except that a cavity further includes an etch stop layer.

First, second, and third unit filters 711, 712, and 713 constituting a first filter array 710 may include first, second, and third cavities 741, 742, and 743 having different effective refractive indexes. Each of the first, second, and third cavities 741, 742, and 743 may include an etch stop layer 740a provided on the first metal reflective layer 631, a first material layer provided on the etch stop layer 740a, and at least one second material layer arranged inside the first material layer. The etch stop layer 740a may facilitate a patterning process for forming a cavity. Although the etch stop layer 740a may include, for example, a silicon oxide, titanium oxide, or hafnium oxide, and the like, embodiments are not limited thereto.

Fourth, fifth, and sixth unit filters 721, 722, and 723 constituting the second filter array 720 may respectively include fourth, fifth, and sixth cavities 761, 762, and 763 having different effective refractive indexes. Each of the fourth, fifth, and sixth cavities 761, 762, and 763 may include an etch stop layer 760a provided on the second metal reflective layers 651 and 652, a first material layer provided on the etch stop layer 760a, and at least one second material layer arranged inside the first material layer.

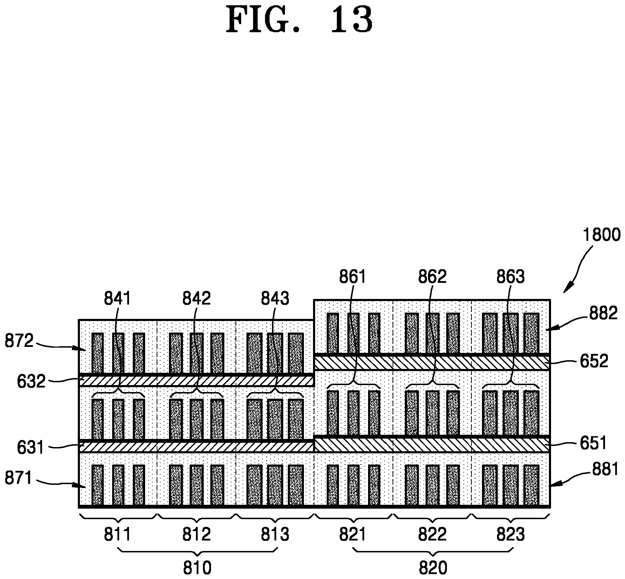

FIG. 13 is a schematic cross-sectional view of a spectral filter 1800 according to another example embodiment. The spectral filter 1800 of FIG. 13 may be substantially the same as the spectral filter 1700 of FIG. 12, except that first and second dielectric layers 871 and 872 are respectively provided below and above first filter array 810, and third and fourth dielectric layers 881 and 882 are respectively provided below and above a second filter array 820.

Referring to FIG. 13, first, second, and third unit filters 811, 812, and 813 constituting the first filter array 810 may include the first metal reflective layers 631 and 632 arranged spaced apart from each other, first, second, and third cavities 841, 842, and 843 provided between the first metal reflective layers 631 and 632, and the first and second dielectric layers 871 and 872 respectively provided below and above the first, second, and third cavities 841, 842, and 843. The first, second, and third unit filters 811, 812, and 813 may respectively include the first, second, and third cavities 841, 842, and 843 having different effective refractive indexes, to have different center wavelengths in the first wavelength range.

The first dielectric layer 871 may be provided below the first metal layer 631, and the second dielectric layer 872 may be provided above the first metal layer 632. The first and second dielectric layers 871 and 872 facilitate transmittance of the first, second, and third unit filters 811, 812, and 813.

Each of the first and second dielectric layers 871 and 872 may include a first material layer and at least one second material layer arranged inside the first material layer and having a refractive index different from the first material layer. Each of the first and second material layers may include, for example, a titanium oxide, a silicon nitride, a hafnium oxide, a silicon oxide, a high index polymer, and the like, but embodiments are not limited thereto. Effective refractive indexes of the first and second dielectric layers 871 and 872 may be adjusted by changing the width of the second material layer according to the center wavelengths of the first, second, and third unit filters 811, 812, and 813. Each of the first and second dielectric layers 871 and 872 may further include an etch stop layer.

Each of fourth, fifth, and sixth unit filters 821, 822, and 823 constituting the second filter array 820 may include the second metal reflective layers 651 and 652 arranged spaced apart from each other, fourth, fifth, and sixth cavities 861, 862, and 863 provided between the second metal reflective layers 651 and 652, and the third and fourth dielectric layers 881 and 882 respectively provided below and above fourth, fifth, and sixth cavities 861, 862, and 863. The fourth, fifth, and sixth unit filters 821, 822, and 823 may respectively include the fourth, fifth, and sixth cavities 861, 862, and 863 having different effective refractive indexes, to have different center wavelengths in the second wavelength range.

The third dielectric layer 881 may be provided below the second metal layer 651, and the fourth dielectric layer 822 may be provided above the second metal layer 652. Each of the third and fourth dielectric layers 881 and 882 may include a first material layer and at least one second material layer arranged inside the first material layer and having a different refractive index from the first material layer. Effective refractive indexes of the third and fourth dielectric layers 881 and 882 may be adjusted by changing the width of the second material layer according to the center wavelengths of the fourth, fifth, and sixth unit filters 821, 822, and 823. Each of the third and fourth dielectric layers 881 and 882 may further include an etch stop layer.

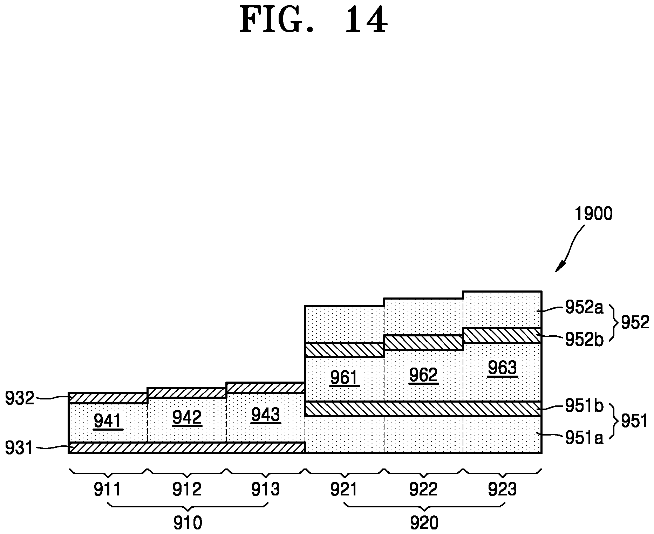

FIG. 14 is a schematic cross-sectional view of a spectral filter 1900 according to another example embodiment.

Referring to FIG. 14, a first filter array 910 may include at least one unit filter having a center wavelength in a first wavelength range, and a second filter array 920 may include at least one unit filter having a center wavelength in a second wavelength range. FIG. 14 illustrates a case in which the first filter array 910 includes first, second, and third unit filters 911, 912, and 913, and the second filter array 920 may include fourth, fifth, and sixth unit filters 921, 922, and 923.

The first wavelength range may be shorter than the second wavelength range. For example, the first wavelength range may be a range of about 250 nm to about 600 nm, and the second wavelength range may be a range of about 600 nm to about 1100 nm. However, this is merely exemplary, and the first and second wavelength ranges may be variously changed according to a design condition. For example, the first wavelength range may be longer than the second wavelength range.

Each of the first, second, and third unit filters 911, 912, and 913 constituting the first filter array 910, which transmits light having a specific center wavelength in the first wavelength range, may have a Fabry-Perot structure in which cavities 941, 942, and 943 are provided between two metal reflective layers 931 and 932 spaced apart from each other.

When light passes through the metal reflective layers 931 and 932 to be incident on the first, second, and third cavities 941, 942, and 943, the light may reciprocate between the metal reflective layers 931 and 932 inside the first, second, and third cavities 941, 942, and 943, during which a constructive interference and a destructive interference occur. Light having a specific center wavelength and satisfying a constructive interference condition may exit to the outside of each of the first, second, and third unit filters 911, 912, and 913. The wavelength band and the center wavelength of the light passing through the first, second, and third unit filters 911, 912, and 913 may be determined according to a reflection band of the metal reflective layers 931 and 932 and the characteristics of the first, second, and third cavities 941, 942, and 943.

The metal reflective layers 931 and 932 may include a certain metal capable of reflecting light in the first wavelength range. When the first wavelength range is shorter than the second wavelength range, each of the metal reflective layers 931 and 932 may include, for example, Al, Ag, Au, TiN**,** and the like. When the first wavelength range is longer than the second wavelength range, the metal reflective layers 931 and 932 may include, for example, Cu, Ag, Au, TiN**,** and the like. However, this is merely exemplary. Although the metal reflective layers 931 and 932 may have a thickness of tens of nanometers, embodiments not limited thereto.

Although the first, second, and third cavities 941, 942, and 943 provided between the metal reflective layers 931 and 932 may include for example, silicon, a silicon oxide, a silicon nitride, or a titanium oxide, embodiments are not limited thereto. The first, second, and third unit filters 911, 912, and 913 may have different center wavelengths in the first wavelength range. To this end, the first, second, and third unit filters 911, 912, and 913 may respectively include the first, second, and third cavities 941, 942, and 943 having different thicknesses. Although not illustrated, as the first, second, and third unit filters 911, 912, and 913 include cavities having different effective refractive indexes, the first, second, and third unit filters 911, 912, and 913 may have different center wavelengths.

Each of the fourth, fifth, and sixth unit filters 921, 922, and 923 constituting the second filter array 920, which transmits light having a specific center wavelength in the second wavelength range, may have a Fabry-Perot structure in which the fourth, fifth, and sixth cavities 961, 962, and 963 are provided between two Bragg reflective layers 951 and 952 spaced apart from each other.

When light passes through the Bragg reflective layers 951 and 952 to be incident on the fourth, fifth, and sixth cavities 961, 962, and 963, the light may reciprocate between the Bragg reflective layers 951 and 952 inside the fourth, fifth, and sixth cavities 961, 962, and 963, during which a constructive interference and a destructive interference occur. Light having a specific center wavelength and satisfying a constructive interference condition may exit to the outside of each of the fourth, fifth, and sixth unit filters 921, 922, and 923. The wavelength band and the center wavelength of the light passing through the first, second, and third unit filters 911, 912, and 913 may be determined according to a reflection band of the Bragg reflective layers 951 and 952 and the characteristics of the fourth, fifth, and sixth cavities 961, 962, and 963.

The Bragg reflective layers 951 and 952 may include a distributed Bragg reflector (DBR). Each of the Bragg reflective layers 951 and 952 may have a structure in which at least one of first material layers 951a and 952a having different refractive indexes and at least one of second material layers 951b and 952b are alternately stacked. The first material layers 951a and 952a or the second material layers 951b and 952b may include, for example, a silicon oxide, a titanium oxide, a silicon nitride, or silicon. However, embodiments are not limited thereto.

When any one of the first and second material layer 951a and 952a, and 951b and 952b constituting the Bragg reflective layers 951 and 952 includes a material, for example, silicon, and the like, capable of absorbing light in the first wavelength range, that is, light of a short wavelength, the light in the first wavelength range may be prevented from passing through the fourth, fifth, and sixth unit filters 921, 922, and 923.

Although the fourth, fifth, and sixth cavities 961, 962, and 963 provided between the Bragg reflective layers 951 and 952 may include, for example, silicon, a silicon oxide, a silicon nitride, a hafnium oxide, or a titanium oxide, embodiments are not limited thereto.

The fourth, fifth, and sixth unit filters 921, 922, and 923 may have different center wavelengths in the second wavelength range. To this end, the fourth, fifth, and sixth unit filters 921, 922, and 923 may include the fourth, fifth, and sixth cavities 961, 962, and 963 having different thicknesses. As the fourth, fifth, and sixth unit filters 921, 922, and 923 include cavities having different effective refractive indexes, the fourth, fifth, and sixth unit filters 921, 922, and 923 may have different center wavelengths.

As described above, as the first filter array 910 in which the first, second, and third cavities 941, 942, and 943 are provided between the metal reflective layers 931 and 932 and the second filter array 920 in which the fourth, fifth, and sixth cavities 961, 962, and 963 are provided between the Bragg reflective layers 951 and 952 are arranged on a plane, a spectral filter having the characteristics of a broadband including the first wavelength range and the second wavelength range may be implemented.

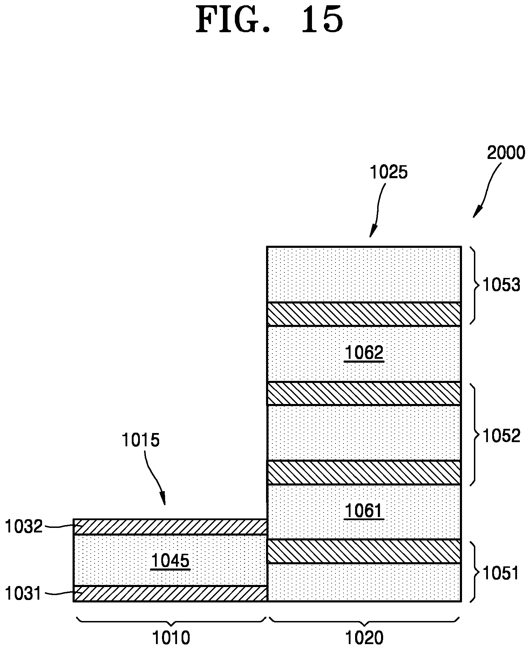

FIG. 15 is a schematic cross-sectional view of a spectral filter 2000 according to another example embodiment. FIG. 15 illustrates a case in which, for convenience of explanation, a first filter array 1010 includes one unit filter (a first unit filter 1015), and a second filter array 1020 includes one unit filter (a second unit filter 1025).

Referring to FIG. 15, the first unit filter 1015 constituting the first filter array 1010 may include two metal reflective layers 1031 and 1032 arranged spaced apart from each other and a first cavity 1045 provided between the metal reflective layers 1031 and 1032. The metal reflective layers 1031 and 1032 and the first cavity 1045 are as described above.

The second unit filter 1025 constituting the second filter array 1020 may have a multi-cavity structure. For example, the second unit filter 1025 may include three Bragg reflective layers 1051, 1052, and 1053 arranged spaced apart from one another and two second cavities 1061 and 1062 provided between the Bragg reflective layers 1051, 1052, and 1053. The Bragg reflective layers 1051, 1052, and 1053 and the second cavities 1061 and 1062 are as described above. The number of first and second material layers constituting each of the Bragg reflective layers 1051, 1052, and 1053 may be variously changed. Although FIG. 15 illustrates a case of the second unit filter 1025 including the second cavities 1061 and 1062, embodiments are not limited thereto, and the second unit filter 1025 may include three or more cavities.

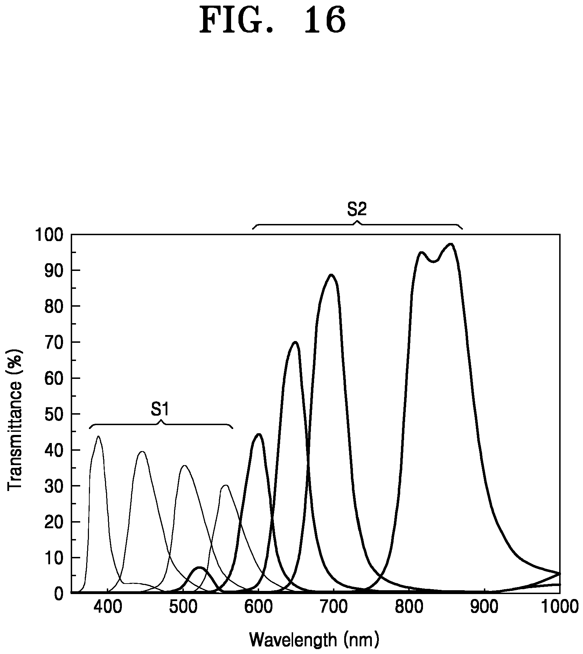

FIG. 16 is a graph of a transmittance spectrum of the spectral filter 2000 of FIG. 15. FIG. 16 shows a transmittance spectrum of a case in which, in the spectral filter 2000 of FIG. 15, the first filter array 1010 includes four unit filters having different center wavelengths and the second filter array 1020 includes four unit filters having different center wavelengths.

In the first filter array 1010, the metal reflective layers 1031 and 1032 include Al, and the first cavity 1045 includes a multi-layer film of TiO₂ and SiN. In the second filter array 1020, each of the Bragg reflective layers 1051, 1052, and 1053 may include Si and SiO₂, and the second cavities 1061 and 1062 include SiO₂. In FIG. 16, "S1" denotes a transmittance spectrum of the first filter array 1010, and "S2" denotes a transmittance spectrum of the second filter array 1020.

In the above description, a case in which the first unit filter 1015 has a single cavity structure and the second unit filter 1025 has a multi-cavity structure is described. However, the first unit filter 1015 may have a multi-cavity structure and the second unit filter 1025 may have a single cavity structure. Furthermore, both of the first and second unit filters 1015 and 1025 may have a multi-cavity structure.

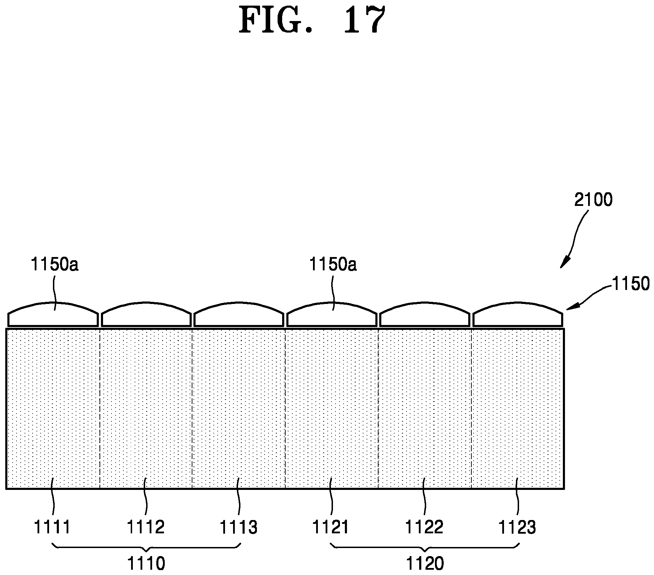

FIG. 17 is a schematic cross-sectional view of a spectral filter 2100 according to another example embodiment.

Referring to FIG. 17, the spectral filter 2100 may include first and second filter arrays 1110 and 1120 and a microlens array 1150 provided above the first and second filter arrays 1110 and 1120. The first filter array 1110 may include first, second, and third unit filters 1111, 1112, and 1113 having center wavelengths in a first wavelength range, and the second filter array 1120 may include fourth, fifth, and sixth unit filters 1121, 1122, and 1123 having center wavelengths in a second wavelength range.

The first filter array 1110 may include any one of the above-described first filter arrays 110 to 1010, and the second filter array 1120 may include any one of the above-described second filter arrays 120 to 1020. The descriptions of the first and second filter arrays 1110 and 1120 are omitted.

The microlens array 1150 having a plurality of microlenses 1150a may be provided above the first and second filter arrays 1110 and 1120. The microlenses 1150a may serve to focus external light to be incident on appropriate unit filters 1111, 1112, 1113, 1121, 1122, and 1123.

FIG. 17 illustrates a case in which the microlenses 1150a are provided to have a one-to-one correspondence to the unit filters 1111, 1112, 1113, 1121, 1122, and 1123. However, this is merely exemplary, and at least two of the unit filters 1111, 1112, 1113, 1121, 1122, and 1123 may be provided corresponding to one microlens 1150a.

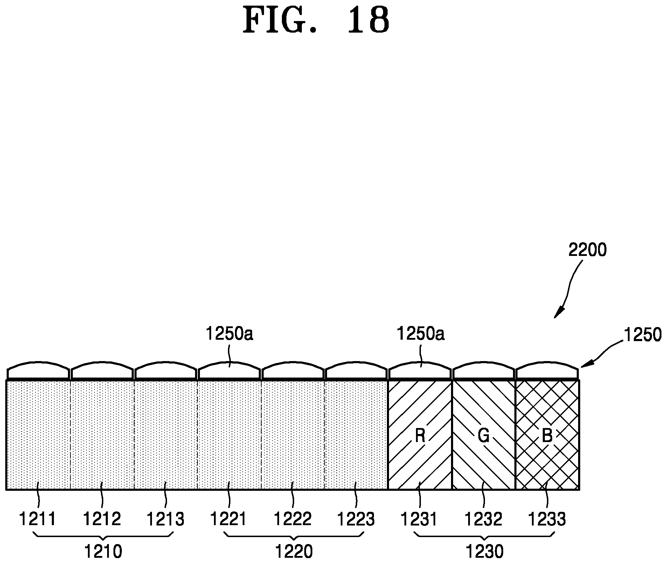

FIG. 18 is a schematic cross-sectional view of a spectral filter 2200 according to another example embodiment.

Referring to FIG. 18, the spectral filter 2200 may include first and second filter arrays 1210 and 1220 and a color filter array 1230. The first and second filter arrays 1210 and 1220 and the color filter array 1230 may be arranged on substantially the same plane.

The first filter array 1210 may include first, second, and third unit filters 1211, 1212, and 1213 having center wavelengths in a first wavelength range, and the second filter array 920 may include fourth, fifth, and sixth unit filters 1221, 1222, and 1223 having center wavelengths in a second wavelength range. The first filter array 1210 may include any one of the above-described first filter arrays 110 to 1010, and the second filter array 1220 may include any one of the above-described second filter arrays 120 to 1020. The descriptions of the first and second filter arrays 1210 and 1220 are omitted.

The color filter array 1230 may include, for example, a red color filter 1231, a green color filter 1232, and a blue color filter 1233. The red color filter 1231 may transmit red light having a wavelength band of about 600 nm to about 700 nm, the green color filter 1232 may transmit green light having a wavelength band of about 500 nm to about 600 nm, and the blue color filter 1233 may transmit blue light having a wavelength band of about 400 nm to about 500 nm. For example, typical color filters applied to color display apparatuses such as liquid crystal display apparatuses, organic light-emitting display apparatuses, and the like may be used as the red, green and blue color filters 1231, 1232, and 1233. A microlens array 1250 including a plurality of microlenses 1250a may be further provided above the first and second filter arrays 1210 and 1220 and the color filter array 1230.

According to an example embodiment, not only information about center wavelengths of the unit filters 1211, 1212, 1213, 1221, 1222, and 1223 may be obtained by using the first and second filter arrays 1210 and 1220, but also information about wavelengths of the red, green, and blue light may be additionally obtained by using the color filter array 1230. The color filter array 1230 may have a greater wavelength band than the first and second filter arrays 1210 and 1220, and may improve the spectral resolution of the image.

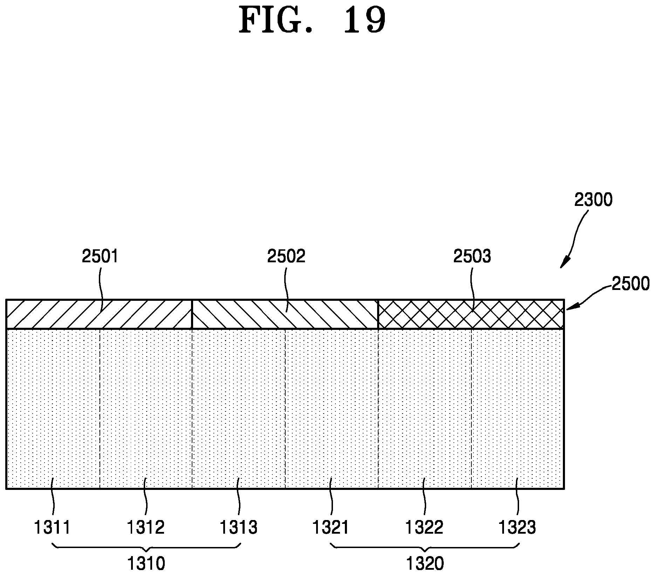

FIG. 19 is a schematic cross-sectional view of a spectral filter 2300 according to another example embodiment.

Referring to FIG. 19, the spectral filter 2300 may include first and second filter array 1310 and 1320 and an additional filter array 2500 provided on the first and second filter array 1310 and 1320. The first filter array 1310 may include first, second, and third unit filters 1311, 1312, and 1313 having center wavelengths in a first wavelength range, and the second filter array 1320 may include fourth, fifth, and sixth unit filters 1321, 1322, and 1323 having center wavelengths in a second wavelength range.

The first filter array 1310 may include any one of the above-described first filter arrays 110 to 1010, and the second filter array 1320 may include any one of the above-described second filter arrays 120 to 1020. The descriptions of the first and second filter array 1310 and 1320 are omitted.

The additional filter array 2500 may include a plurality of first to third additional filters 2501, 2502, and 2503. FIG. 19 illustrates a case in which the first additional filter 2501 is provided to correspond to the first and second unit filters 1311 and 1312, the second additional filter 2502 is provided to corresponding to the third and fourth unit filters 1313 and 1321, and the third additional filter 2503 is provided to correspond to the fifth and sixth unit filters 1322 and 1323. However, this is merely exemplary, and each of the first, second, and third additional filters 2501, 2502, and 2503 may be provided to correspond to one unit filter (1311, 1312, 1313, 1321, 1322, or 1323) or three or more unit filters (1311, 1312, 1313, 1321, 1322, and 1323).

Each of the first, second, and third additional filters 2501, 2502, and 2503 may block light in a wavelength band that the corresponding unit filters (1311, 1312, 1313, 1321, 1322, and 1323) do not desire. For example, when the first and second unit filters 1311 and 1312 have center wavelengths in a wavelength band of about 400 nm to about 500 nm, the first additional filter 2501 may include a blue filter that transmits blue light. Furthermore, when the third and fourth unit filters 1313 and 1321 have center wavelengths in a wavelength band of about 500 nm to about 600 nm, the second additional filter 2502 may include a green filter that transmits green light. When the fifth and sixth unit filters 1322 and 1323 have center wavelengths in a wavelength band of about 600 nm to about 700 nm, the third additional filter 2503 may include red filter that transmits red light.

The additional filter array 2500 may include a color filter array. In this case, the first, second, and third additional filters 2501, 2502, and 2503 may respectively include blue, green, and red color filters. For example, typical color filters applied to color display apparatuses such as liquid crystal display apparatuses, organic light-emitting display apparatuses, and the like may be used as the blue, green, and red color filters.

The additional filter array 2500 may include a broadband filter array. In this case, the first, second, and third additional filters 2501, 2502, and 2503 may respectively include first, second, and third broadband filters. Each of the first, second, and third broadband filters may have, for example, a multi-cavity structure or a metal mirror structure.

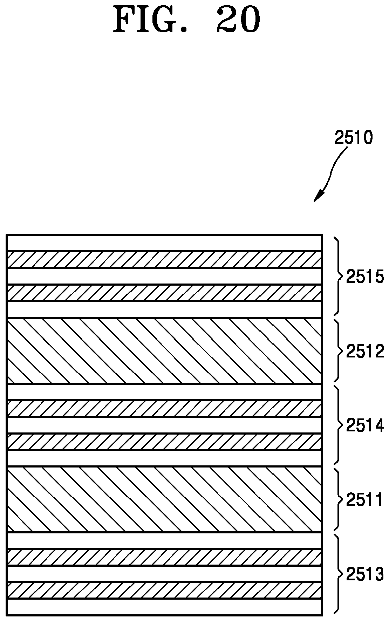

FIG. 20 is a schematic cross-sectional view of a broadband filter 2510 that is usable as the additional filter of FIG. 19 according to an example embodiment.

Referring to FIG. 20, the broadband filter 2510 may include a plurality of reflective layers 2513, 2514, and 2515 arranged spaced apart from one another and a plurality of cavities 2511 and 2512 provided between the reflective layers 2513, 2514, and 2515. Although FIG. 20 illustrates an example of the three reflective layers 2513, 2514, and 2515 and the two cavities 2511 and 2512, the numbers of the reflective layers 2513, 2514, and 2515 and the cavities 2511 and 2512 may be variously changed.

Each of the reflective layers 2513, 2514, and 2515 may include a DBR. Each of the reflective layers 2513, 2514, and 2515 may have a structure in which a plurality of material layers having different refractive indexes are alternately stacked. Each of the cavities 2511 and 2512 may include a material having a certain refractive index or two or more materials having different refractive indexes.

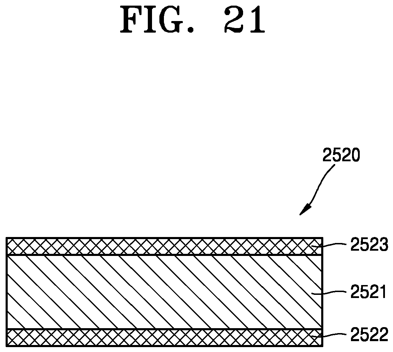

FIG. 21 is a schematic cross-sectional view of a broadband filter 2520 that is usable as the first to third additional filters 2501, 2502, and 2503 of FIG. 19, according to another example embodiment.

Referring to FIG. 21, the broadband filter 2520 may include two metal mirror layers 2522 and 2523 arranged spaced apart from each other and a cavity 2521 provided between the metal mirror layers 2522 and 2523.

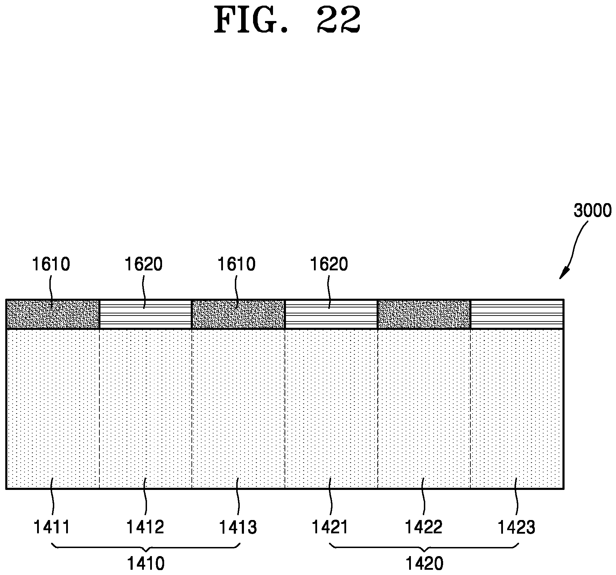

FIG. 22 is a schematic cross-sectional view of a spectral filter 3000 according to another example embodiment.

Referring to FIG. 22, the spectral filter 3000 may include first and second filter arrays 1410 and 1420, and a short wavelength absorption filter 1610 and a long wavelength cut-off filter 1620 provided on the first and second filter arrays 1410 and 1420.

The first filter array 1410 may include first, second, and third unit filters 1411, 1412, and 1413 having center wavelengths in a first wavelength range, and the second filter array 1420 may include fourth, fifth, and sixth unit filters 1421, 1422, and 1423 having center wavelengths in a second wavelength range.

The first filter array 1410 may include any one of the above-described first filter arrays 110 to 1010, and the second filter array 1420 may include any one of the above-described second filter arrays 120 to 1020. The descriptions of the first and second filter arrays 1410 and 1420 are omitted.

The short wavelength absorption filter 1610 may be provided in some unit filters (1411, 1413, and 1422) of the first to sixth unit filters 1411, 1412, 1413, 1421, 1422, and 1423, and the long wavelength cut-off filter 1620 may be provided in the other unit filters (1412, 1421, and 1423) of the first to sixth unit filters 1411, 1412, 1413, 1421, 1422, and 1423. Although FIG. 22 illustrates a case in which each of the short wavelength absorption filter 1610 and the long wavelength cut-off filter 1620 is provided to correspond to one unit filter (1411, 1412, 1413, 1421, 1422, or 1423), embodiments are not limited thereto, and each of the short wavelength absorption filter 1610 and the long wavelength cut-off filter 1620 may be provided to correspond to two or more unit filters (1411, 1412, 1413, 1421, 1422, and 1423).

The short wavelength absorption filter 1610 may cut off, for example, light of a short wavelength such as visible light. The short wavelength absorption filter 1610 may be manufactured by depositing, for example, silicon that is a material for absorbing visible light, on some unit filters (1411, 1413, and 1422) of the first to sixth unit filters 1411, 1412, 1413, 1421, 1422, and 1423. The unit filters (1411, 1413, and 1422) where the short wavelength absorption filter 1610 is provided may transmit near infrared (NIR) light having a wavelength longer than the visible light.

The long wavelength cut-off filter 1620 may cut off, for example, light having a long wavelength such as NIR light. The long wavelength cut-off filter 1620 may include a NIR light cut-off filter. The unit filters (1412, 1421, and 1423) where the long wavelength cut-off filter 1620 is provided may transmit visible light having a wavelength shorter than NIR light.

According to an example embodiment, as the short wavelength absorption filter 1610 and the long wavelength cut-off filter 1620 are provided on the first and second filter arrays 1410 and 1420, the spectral filter 3000 having the broadband characteristics capable implementing from a visible light band to an NIR band may be manufactured.

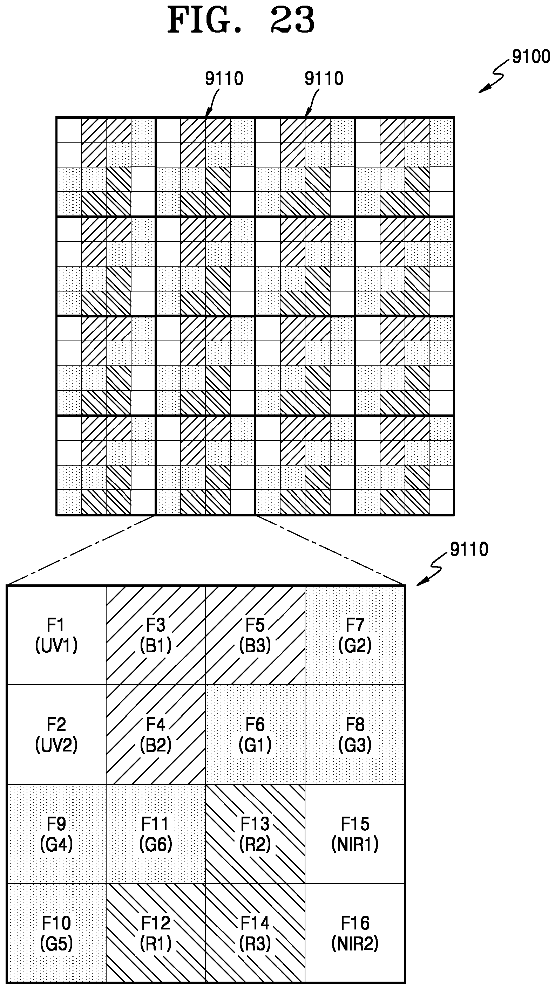

FIG. 23 is a plan view of an example of a spectral filter 9100 that is applicable to the image sensor 1000 of FIG. 1.

Referring to FIG. 23, the spectral filter 9100 may include a plurality of filter groups 9110 arranged in two dimensions. Each of the filter groups 9110 may include sixteen unit filters F1 to F16 arranged in a 4×4 array.

The first and second unit filters F1 and F2 may have center wavelengths UV1 and UV2 in an ultraviolet range, and the third to fifth unit filters F3 to F5 may have center wavelengths B1 to B3 in a blue light range. The sixth to eleventh unit filter F6 to F11 may have center wavelengths G1 to G6 in a green light range, and the twelfth to fourteenth unit filters F12 to F14 may have center wavelengths R1 to R3 in a red light range. The fifteenth and sixteenth unit filters F15 and F16 may have center wavelengths NIR1 and NIR2 in a near infrared range.

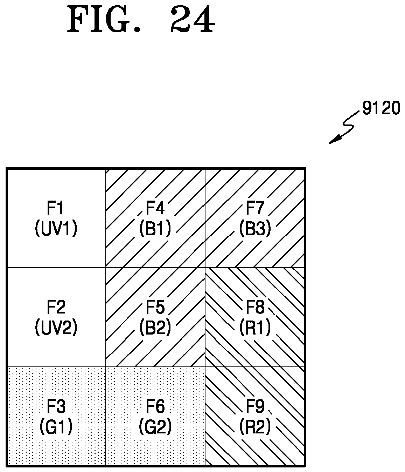

FIG. 24 is a plan view of another example of the spectral filter 9100 that is applicable to the image sensor 1000 of FIG. 1. FIG. 24 is a plan view of one filter group 9120, for convenience of explanation.

Referring to FIG. 24, each filter group 9120 may include nine unit filters F1 to F9 arranged in a 3×3 array. The first and second unit filters F1 and F2 may have center wavelengths UV1 and UV2 in the ultraviolet range, and the fourth, fifth, and seventh unit filter F4, F5, and F7 may have center wavelengths B1 to B3 in the blue light range. The third and sixth unit filters F3 and F6 may have center wavelengths G1 and G2 in the green light range, and the eighth and ninth unit filters F8 and F9 may have center wavelengths R1 and R2 in the red light range.

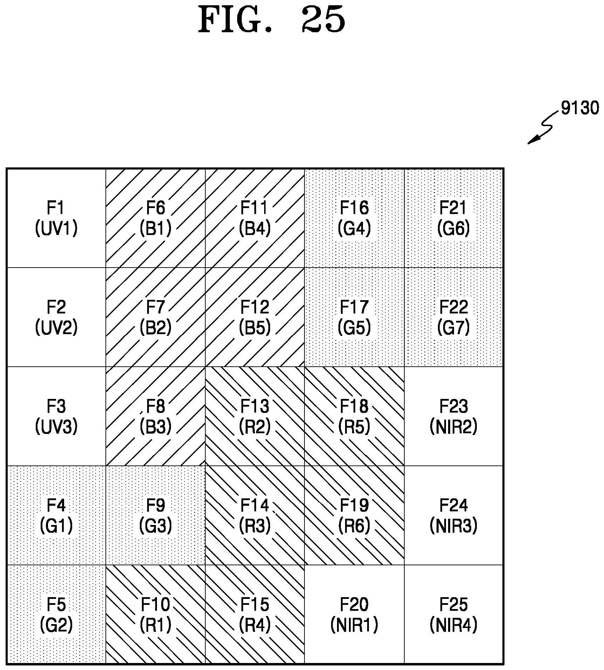

FIG. 25 is a plan view of another example of the spectral filter 9100 that is applicable to the image sensor 1000 of FIG. 1. FIG. 25 is a plan view of one filter group 9130, for convenience of explanation.

Referring to FIG. 25, each filter group 9130 may include twenty-five unit filters F1 to F25 arranged in a 5×5 array. The first to third unit filter F1 to F3 may have center wavelengths UV1 to UV3 in the ultraviolet range, and the sixth, seventh, eighth, eleventh, and twelfth unit filters F6, F7, F8, F11, and F12 may have center wavelengths B1 to B5 in the blue light range. The fourth, fifth, and ninth unit filters F4, F5, and F9 may have center wavelengths G1 to G3 in the green light range, and the tenth, thirteenth, fourteenth, fifteenth, eighteenth, and nineteenth unit filters F10, F13, F14, F15, F18, and F19 may have center wavelengths R1 to R6 in a red light range. The twentieth, twenty-third twenty-fourth, and twenty-fifth unit filters F20, F23, F24, and F25 may have center wavelengths NIR1 to NIR4 in the near infrared range.

The image sensor 1000 having the above-described spectral filter may be employed in various high performance optical devices or high performance electronic devices. The electronic devices may include, for example, smart phones, mobile phones, cellular phones, personal digital assistants (PDAs), laptop computers, personal computers (PCs), various portable devices, home appliances, security cameras, medical cameras, automobiles, Internet of Things (IoT) devices, and other mobile or no-mobile computing devise, but embodiments are not limited thereto.

The electronic devices may further include, in addition to the image sensor 1000, a processor for controlling an image sensor, for example, an application processor (AP), control a number of hardware or software constituent elements by driving operating systems or application programs through the processor, and perform various data processing and calculations. The processors may further include graphics processing units (GPUs) and/or image signal processors. When the processors include image signal processors, an image (or video) obtained through an image sensor may be store and/or output using the processor.

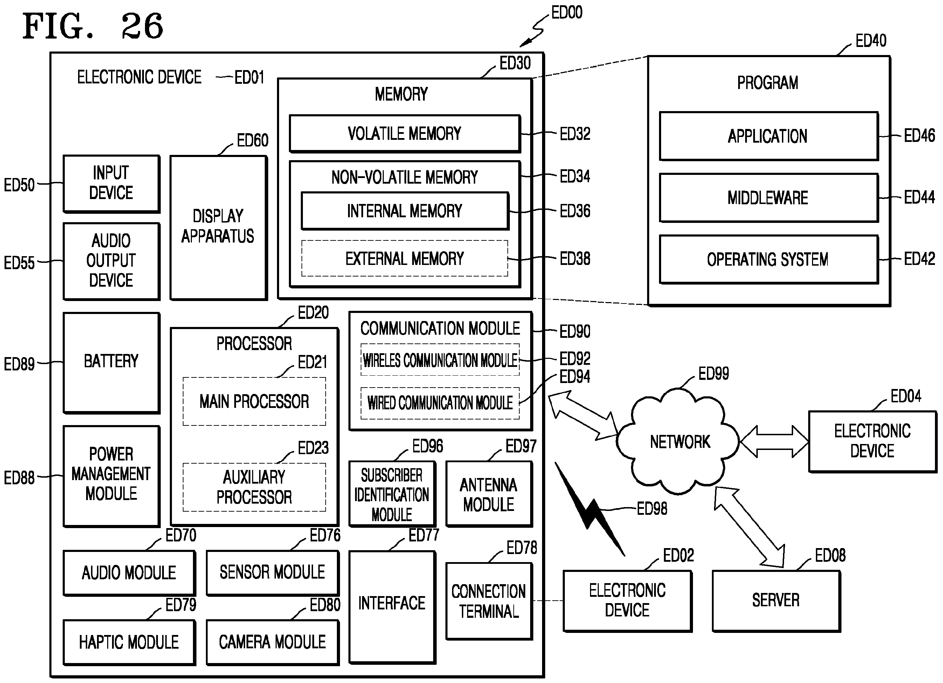

FIG. 26 is a schematic block diagram of an electronic device ED01 including the image sensor 1000, according to an embodiment. Referring to FIG. 26, in a network environment ED00, the electronic device ED01 may communicate with another electronic device ED02 through a first network ED98 (short-range wireless communication network, and the like), or communicate with another electronic device ED04 and/or a server ED08 through a second network ED99 (long-range wireless communication network, and the like). The electronic device ED01 may communicate with the electronic device ED04 through the server ED08. The electronic device ED01 may include a processor ED20, a memory ED30, an input device ED50, an audio output device ED55, a display apparatus ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic device ED01, some (the display apparatus ED60, and the like) of constituent elements may be omitted or other constituent elements may be added. Some of the constituent elements may be implemented by one integrated circuit. For example, the sensor module ED76 (a fingerprint sensor, an iris sensor, an illuminance sensor, and the like) may be implemented by being embedded in the display apparatus ED60 (a display, and the like). Furthermore, when the image sensor 1000 includes a spectral function, some functions (a color sensor and an illuminance sensor) of the sensor module ED76 may be implemented by the image sensor 1000, not by a separate sensor module.

The processor ED20 may control one or a plurality of other constituent elements (hardware and software constituent elements, and the like) of the electronic device ED01 connected to the processor ED20 by executing software (a program ED40, and the like), and perform various data processing or calculations. As part of the data processing or calculations, the processor ED20 may load, in a volatile memory ED32, commands and/or data received from other constituent elements (the sensor module ED76, the communication module ED90, and the like), process the command and/or data stored in the volatile memory ED32, and store result data in a non-volatile memory ED34. The processor ED20 may include a main processor ED21 (a central processing unit, an application processor, and the like) and an auxiliary processor ED23 (a graphics processing unit, an image signal processor, a sensor hub processor, a communication processor, and the like) that is operable independently of or together with the main processor ED21. The auxiliary processor ED23 may use less power than the main processor ED21 and may perform a specialized function.

Instead of the main processor ED21 when the main processor ED21 is in an inactive state (sleep state), or with the main processor ED21 when the main processor ED21 is in an active state (application execution state), the auxiliary processor ED23 may control functions and/or states related to some constituent elements (the display apparatus ED60, the sensor module ED76, the communication module ED90, and the like) of the constituent elements of the electronic device ED01. The auxiliary processor ED23 (an image signal processor, a communication processor, and the like) may be implemented as a part of functionally related other constituent elements (the camera module ED80, the communication module ED90, and the like).

The memory ED30 may store various data needed by the constituent elements (the processor ED20, the sensor module ED76, and the like) of the electronic device ED01. The data may include, for example, software (the program ED40, and the like) and input data and/or output data about commands related thereto. The memory ED30 may include the volatile memory ED32 and/or the non-volatile memory ED34. The non-volatile memory ED34 may include an internal memory ED36 fixedly installed in the electronic device ED01 and an external memory ED38 that is removable.

The program ED40 may be stored in the memory ED30 as software, and may include an operating system ED42, middleware ED44, and/or an application ED46.

The input device ED50 may receive commands and/or data to be used for constituent elements (the processor ED20, and the like) of the electronic device ED01, from the outside (a user, and the like) of the electronic device ED01. The input device ED50 may include a microphone, a mouse, a keyboard, and/or a digital pen (a stylus pen, and the like).

The audio output device ED55 may output an audio signal to the outside of the electronic device ED01. The audio output device ED55 may include a speaker and/or a receiver. The speaker may be used for general purposes such as multimedia playback or recording playback, and the receiver can be used to receive incoming calls. The receiver may be implemented by being coupled as a part of the speaker or by an independent separate device.

The display apparatus ED60 may visually provide information to the outside of the electronic device ED01. The display apparatus ED60 may include a display, a hologram device, or a projector, and a control circuit to control a corresponding device. The display apparatus ED60 may include a touch circuitry set to detect a touch and/or a sensor circuit (a pressure sensor, and the like) set to measure the strength of a force generated by the touch.

The audio module ED70 may convert sound into electrical signals or reversely electrical signals into sound. The audio module ED70 may obtain sound through the input device ED50, or output sound through a speaker and/or a headphone of another electronic device (the electronic device ED02, and the like) connected to the audio output device ED55 and/or the electronic device ED01 in a wired or wireless manner.

The sensor module ED76 may detect an operation state (power, temperature, and the like) of the electronic device ED01, or an external environment state (a user state, and the like), and generate an electrical signal and/or a data value corresponding to a detected state. The sensor module ED76 may include a gesture sensor, a gyro sensor, a barometric pressure sensor, a magnetic sensor, an acceleration sensor, a grip sensor, a proximity sensor, a color sensor, an IR sensor, a biometric sensor, a temperature sensor, a humidity sensor, and/or an illuminance sensor.

The interface ED77 may support one or a plurality of specified protocols used for the electronic device ED01 to be connected to another electronic device (the electronic device ED02, and the like) in a wired or wireless manner. The interface ED77 may include a high definition multimedia interface (HDMI), a universal serial bus (USB) interface, an SD card interface, and/or an audio interface.

A connection terminal ED78 may include a connector for the electronic device ED01 to be physically connected to another electronic device (the electronic device ED02, and the like). The connection terminal ED78 may include an HDMI connector, a USB connector, an SD card connector, and/or an audio connector (a headphone connector, and the like).

The haptic module ED79 may convert electrical signals into mechanical stimuli (vibrations, movements, and the like) or electrical stimuli that are perceivable by a user through tactile or motor sensations. The haptic module ED79 may include a motor, a piezoelectric device, and/or an electrical stimulation device.

The camera module ED80 may capture a still image and a video. The camera module ED80 may include a lens assembly including one or a plurality of lenses, the image sensor 1000 of FIG. 1, image signal processors, and/or flashes. The lens assembly included in the camera module ED80 may collect light emitted from a subject for image capturing.

The power management module ED88 may manage power supplied to the electronic device ED01. The power management module ED88 may be implemented as a part of a power management integrated circuit (PMIC).

The battery ED89 may supply power to the constituent elements of the electronic device ED01. The battery ED89 may include non-rechargeable primary cells, rechargeable secondary cells, and/or fuel cells.

The communication module ED90 may establish a wired communication channel and/or a wireless communication channel between the electronic device ED01 and another electronic device (the electronic device ED02, the electronic device ED04, the server ED08, and the like), and support a communication through an established communication channel. The communication module ED90 may be operated independent of the processor ED20 (the application processor, and the like), and may include one or a plurality of communication processors supporting a wired communication and/or a wireless communication. The communication module ED90 may include a wireless communication module ED92 (a cellular communication module, a short-range wireless communication module, a global navigation satellite system (GNSS) communication module, and the like), and/or a wired communication module ED94 (a local area network (LAN) communication module, a power line communication module, and the like). Among the above communication modules, a corresponding communication module may communicate with another electronic device through the first network ED98 (a short-range communication network such as Bluetooth, WiFi Direct, or infrared data association (IrDA)) or the second network ED99 (a long-range communication network such as a cellular network, the Internet, or a computer network (LAN, WAN, and the like)). These various types of communication modules may be integrated into one constituent element (a single chip, and the like), or may be implemented as a plurality of separate constituent elements (multiple chips). The wireless communication module ED92 may verify and authenticate the electronic device ED01 in a communication network such as the first network ED98 and/or the second network ED99 by using subscriber information (an international mobile subscriber identifier (IMSI), and the like) stored in the subscriber identification module ED96.

The antenna module ED97 may transmit signals and/or power to the outside (another electronic device, and the like) or receive signals and/or power from the outside. An antenna may include an emitter formed in a conductive pattern on a substrate (a printed circuit board (PCB), and the like). The antenna module ED97 may include one or a plurality of antennas. When the antenna module ED97 includes a plurality of antennas, the communication module ED90 may select, from among the antennas, an appropriate antenna for a communication method used in a communication network such as the first network ED98 and/or the second network ED99. Signals and/or power may be transmitted or received between the communication module ED90 and another electronic device through the selected antenna. Other parts (an RFIC, and the like) than the antenna may be included as a part of the antenna module ED97.

Some of the constituent elements may be connected to each other through a communication method between peripheral devices (a bus, general purpose input and output (GPIO), a serial peripheral interface (SPI), a mobile industry processor interface (MIPI), and the like) and may mutually exchange signals (commands, data, and the like).

The command or data may be transmitted or received between the electronic device ED01 and the external electronic device ED04 through the server ED08 connected to the second network ED99. The electronic devices ED02 and ED04 may be of a type that is the same as or different from the electronic device ED01. All or a part of operations executed in the electronic device ED01 may be executed in one or a plurality of the electronic devices (ED02, ED04, and ED08). For example, when the electronic device ED01 needs to perform a function or service, the electronic device ED01 may request one or a plurality of electronic devices to perform part of the whole of the function or service, instead of performing the function or service. The one or a plurality of the electronic devices receiving the request may perform additional function or service related to the request, and transmit a result of the performance to the electronic device ED01. To this end, cloud computing, distributed computing, and/or client-server computing technology may be used.

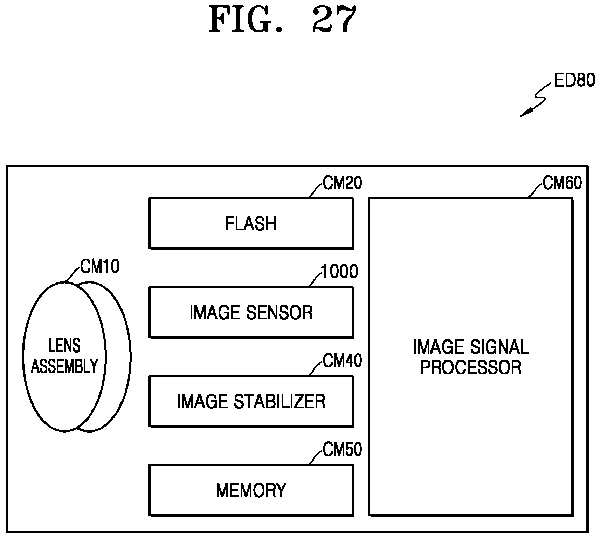

FIG. 27 is a schematic block diagram of the camera module ED80 of FIG. 26. Referring to FIG. 27, the camera module ED80 may include a lens assembly CM10, a flash CM20, the image sensor 1000 (the image sensor 1000 of FIG. 1, and the like), an image stabilizer CM40, a memory CM50 (a buffer memory, and the like), and/or an image signal processor CM60. The lens assembly CM10 may collect light emitted from a subject for image capturing. The camera module ED80 may include a plurality of lens assemblies CM10, and in this case, the camera module ED80 may include a dual camera, a 360 degrees camera, or a spherical camera. Some of the lens assemblies CM10 may have the same lens attributes (a viewing angle, a focal length, auto focus, F Number, optical zoom, and the like), or different lens attributes. The lens assembly CM10 may include a wide angle lens or a telescopic lens.

The flash CM20 may emit light used to reinforce light emitted or reflected from a subject. The flash CM20 may include one or a plurality of light-emitting diodes (a red-green-blue (RGB) LED, a white LED, an infrared LED, an ultraviolet LED, and the like), and/or a xenon lamp. The image sensor 1000 may include the image sensor of FIG. 1, and convert light emitted or reflected from the subject and transmitted through the lens assembly CM10 into electrical signals, thereby obtaining an image corresponding to the subject. The image sensor 1000 may include one or a plurality of sensors selected from image sensors having different attributes such as an RGB sensor, a black and white (BW) sensor, an IR sensor, or UV sensor. Each sensor included in the image sensor 1000 may be implemented by a charged coupled device (CCD) sensor and/or a complementary metal oxide semiconductor (CMOS) sensor.

The image stabilizer CM40 may move, in response to a movement of the camera module ED80 or an electronic device ED01 including the same, one or a plurality of lenses included in the lens assembly CM10 or the image sensor 1000 in a particular direction or may compensate a negative effect due to the movement by controlling (adjusting a read-out timing, and the like) the movement characteristics of the image sensor 1000. The image stabilizer CM40 may detect a movement of the camera module ED80 or the electronic device ED01 by using a gyro sensor (not shown) or an acceleration sensor (not shown) arranged inside or outside the camera module ED80. The image stabilizer CM40 may be implemented in an optical form.

The memory CM50 may store a part or entire data of an image obtained through the image sensor 1000 for a subsequent image processing operation. For example, when a plurality of images are obtained at high speed, only low resolution images are displayed while the obtained original data (Bayer-Patterned data, high resolution data, and the like) is stored in the memory CM50. Then, the memory CM50 may be used to transmit the original data of a selected (user selection, and the like) image to the image signal processor CM60. The memory CM50 may be incorporated into the memory ED30 of the electronic device ED01, or configured to be an independently operated separate memory.

The image signal processor CM60 may perform image processing on the image obtained through the image sensor 1000 or the image data stored in the memory CM50. The image processing may include depth map generation, three-dimensional modeling, panorama generation, feature point extraction, image synthesis, and/or image compensation (noise reduction, resolution adjustment, brightness adjustment, blurring, sharpening, softening, and the like). The image signal processor CM60 may perform control (exposure time control, or read-out timing control, and the like) on constituent elements (the image sensor 1000, and the like) included in the camera module ED80. The image processed by the image signal processor CM60 may be stored again in the memory CM50 for additional processing or provided to external constituent elements (the memory ED30, the display apparatus ED60, the electronic device ED02, the electronic device ED04, the server ED08, and the like) of the camera module ED80. The image signal processor CM60 may be incorporated into the processor ED20, or configured to be a separate processor operated independently of the processor ED20. When the image signal processor CM60 is configured by a separate processor from the processor ED20, the image processed by the image signal processor CM60 may undergo additional image processing by the processor ED20 and then displayed through the display apparatus ED60.

The electronic device ED01 may include a plurality of camera modules ED80 having different attributes or functions. In this case, one of the camera modules ED80 may be a wide angle camera, and another may be a telescopic camera. Similarly, one of the camera modules ED80 may be a front side camera, and another may be a read side camera.

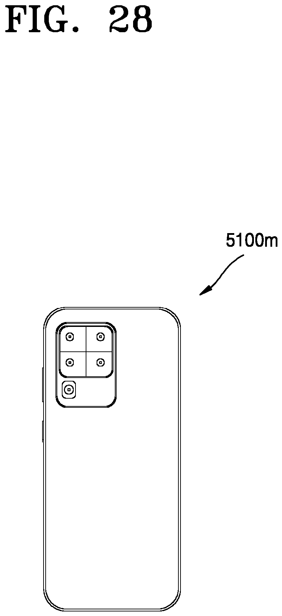

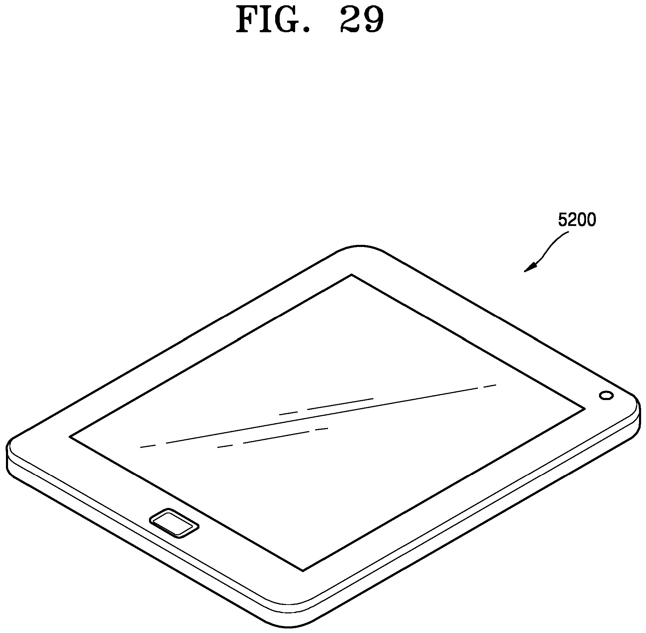

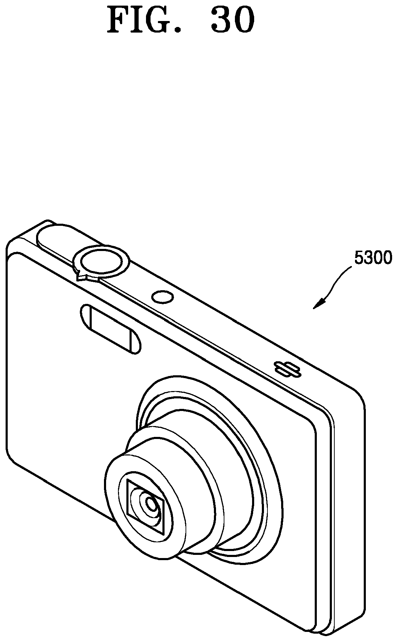

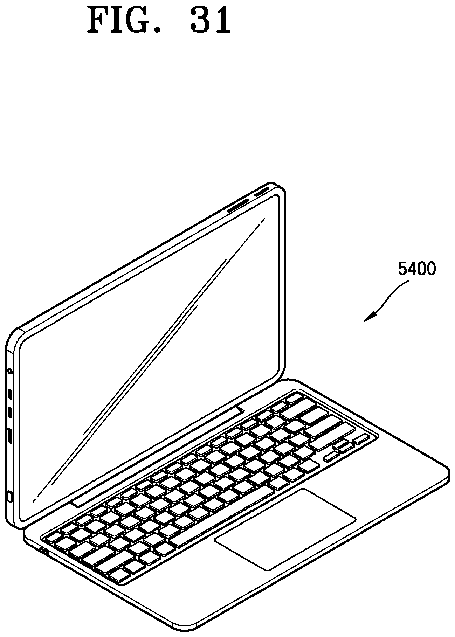

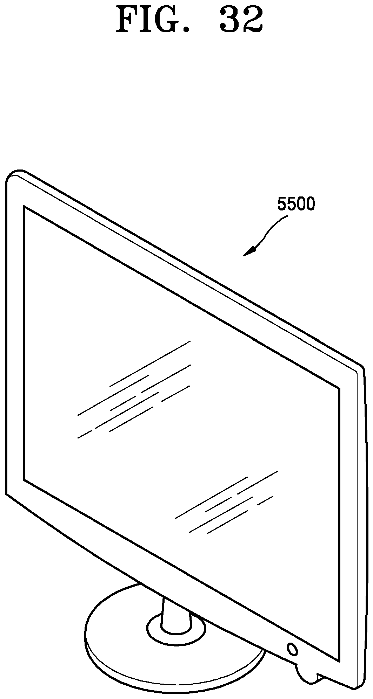

The image sensor 1000 according to embodiments may be applied to a mobile phone or smartphone 5100m illustrated in FIG. 28, a tablet or smart tablet 5200 illustrated in FIG. 29, a digital camera or camcorder 5300 illustrated in FIG. 30, a notebook computer 5400 illustrated in FIG. 31, a television or smart television 5500 illustrated in FIG. 32, and the like. For example, the smartphone 5100m or the smart tablet 5200 may include a plurality of high resolution cameras, each having a high resolution image sensor mounted thereon. Depth information of subjects in an image may be extracted by using a high resolution cameras, out focusing of the image may be adjusted, or subjects in the image may be automatically identified.

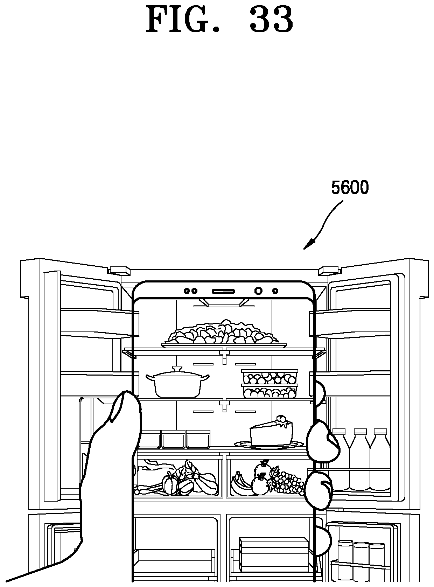

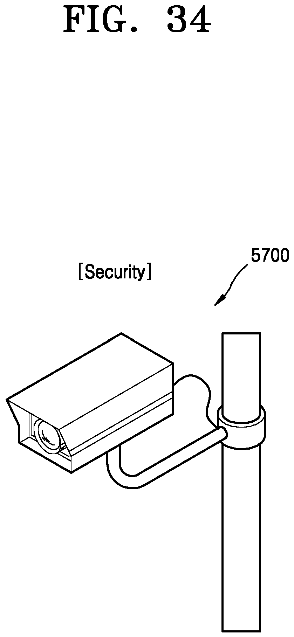

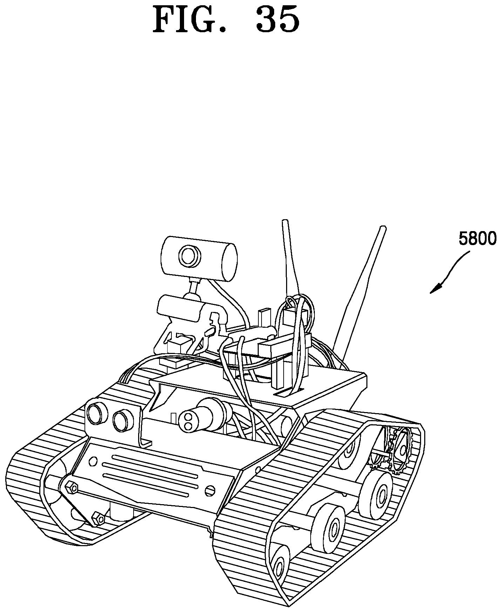

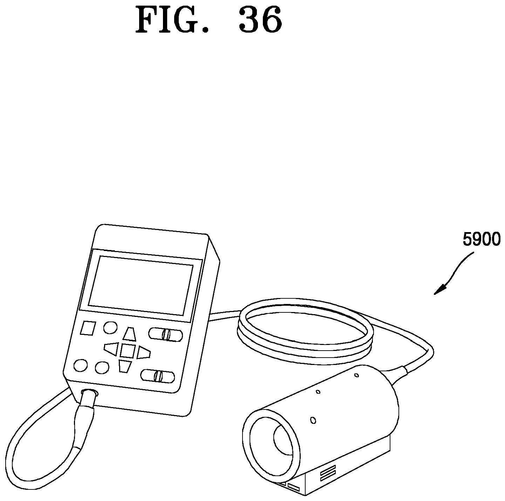

Furthermore, the image sensor 1000 may be applied to a smart refrigerator 5600 illustrated in FIG. 33, a security camera 5700 illustrated in FIG. 34, a robot 5800 illustrated in FIG. 35, a medical camera 5900 illustrated in FIG. 36, and the like. For example, the smart refrigerator 5600 may automatically recognize food in a refrigerator, by using an image sensor, and notify a user of the presence of a particular food, the type of food that is input or output, and the like, through a smartphone. The security camera 5700 may provide an ultrahigh resolution image and may recognize an object or a person in an image in a dark environment by using high sensitivity. The robot 5800 may be provided in a disaster or industrial site that is not directly accessible by people, and may provide a high resolution image. The medical camera 5900 may provide a high resolution image for diagnosis or surgery, and thus a field of vision may be dynamically adjusted.

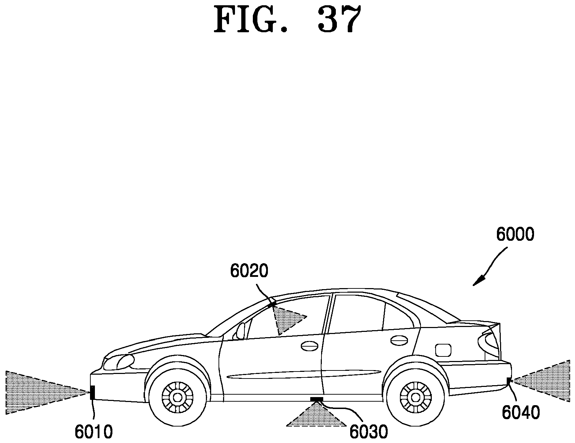

Furthermore, the image sensor 1000 may be applied to a vehicle 6000 as illustrated in FIG. 37. The vehicle 6000 may include a plurality of vehicle cameras 6010, 6020, 6030, and 6040 arranged at various positions. Each of the vehicle cameras 6010, 6020, 6030, and 6040 may include an image sensor according to an embodiment. The vehicle 6000 may provide a driver with various pieces of information about the inside or periphery of the vehicle 6000, by using the vehicle cameras 6010, 6020, 6030, and 6040, and thus an object or a person in an image may be automatically recognized and information needed for autonomous driving is provided.

It should be understood that embodiments described herein should be considered in a descriptive sense only and not for purposes of limitation. Descriptions of features or aspects within each example embodiment should typically be considered as available for other similar features or aspects in other embodiments.

While example embodiments have been described with reference to the figures, it will be understood by those of ordinary skill in the art that various changes in form and details may be made therein without departing from the scope as defined by the following claims.

## Claims

1. A spectral filter (1100; 1200; 1300) comprising:
a first unit filter (111; 211) having a first center wavelength in a first wavelength range; and
a second unit filter (121; 221) having a second center wavelength in a second wavelength range,
wherein the first unit filter (111; 211) comprises:
two first metal reflective layers (131, 132) provided spaced apart from each other and comprising a first metal; and
a first cavity (141) provided between the two first metal reflective layers (131, 132), and
wherein the second unit filter (121; 221) comprises:
two second metal reflective layers (151, 152) provided spaced apart from each other and comprising a second metal different from the first metal; and
a second cavity (161) provided between the two second metal reflective layers (151, 152),
wherein the first unit filter (111; 211) and the second unit filter (121; 221) are provided in one dimension or two dimensions on a plane;
**the spectral filter (1100; 1200; 1300) characterized in that**
the first unit filter (111; 211) is included in a first filter array (110; 210; 310) comprising a plurality of first unit filters (111-113; 211-213; 315) having different center wavelengths in the first wavelength range, and
the second unit filter (121; 221) is included in a second filter array (120; 220; 320) comprising a plurality of second unit filters (121-123; 221-223; 325) having different center wavelengths in the second wavelength range,
wherein each of the first unit filters (111-113; 211-213; 315) included in the first filter array (110; 210; 310) and each of the second unit filters (121-123; 221-223; 325) included in the second filter array (120; 220; 320) comprises a cavity (141-143, 161-161; 145, 165) and the cavities (141-143, 161-161; 145, 165) having different thicknesses or effective indexes, in particular, the thickness or the effective index of the cavities (141-143, 161-161; 145, 165) with respect to each of the first filter array (110; 210; 310) and the second filter array (120; 220; 320) is subsequently increased.

2. The spectral filter (1100; 1200; 1300) of claim 1, wherein the first center wavelength in the first wavelength range is shorter than the second center wavelength in the second wavelength range,
wherein the first center wavelength of the first unit filter (111; 211) is configured to be adjusted based on changing the thickness or an effective refractive index of the first cavity (141), and
wherein the second center wavelength of the second unit filter (121; 221) is configured to be adjusted based on changing the thickness or an effective refractive index of the second cavity (161).

3. The spectral filter (1100; 1200; 1300) of claim 2, wherein the two first metal reflective layers (131, 132) comprise one of aluminum (Al), silver (Ag), gold (Au), or titanium nitride (TiN), and
wherein the two second metal reflective layers (151, 152) comprise one of copper (Cu), Ag, Au, or TiN that is different from the two first metal reflective layers (131, 132).

4. The spectral filter (1100; 1200; 1300) of one of claims 1 to 3, wherein the first unit filter (111; 211) further comprises a first dielectric layer (171; 371) that is provided below the first cavity (141) and a second dielectric layer (172; 372) provided above the first cavity (141),
wherein the second unit filter (121; 221) further comprises a third dielectric layer (181; 381) provided below the second cavity (161) and a fourth dielectric layer (182; 382) provided above the second cavity (161),
wherein each of the first dielectric layer (171; 371), the second dielectric layer (172; 372), the third dielectric layer (181; 381), and the fourth dielectric layer (182; 382) comprises a single layer or multiple layers, and
wherein each of the first dielectric layer (171; 371), the second dielectric layer (171; 372), the third dielectric layer (181; 381), and the fourth dielectric layer (182; 382) has a thickness ranging from 10 nm to 20000 nm.

5. The spectral filter (1100; 1200; 1300) of claim 4, wherein at least one of a thickness or an effective refractive index of each of the first dielectric layer (171; 371) and the second dielectric layer (172; 372) is adjusted based on the first center wavelength of the first unit filter (111; 211), and
wherein a thickness or an effective refractive index of each of the third dielectric layer (181; 381) and the fourth dielectric layer (182; 382) is adjusted based on the second center wavelength of the second unit filter (121; 221).

6. An image sensor (1000) comprising:
the spectral filter (1100; 1200; 1300) according to claim 1; and
a pixel array (4100) configured to receive light transmitted through the spectral filter (1100; 1200; 1300).

7. The image sensor (1000) of claim 6, wherein the first unit filter (111; 211) further comprises a first dielectric layer (171; 371) provided below the first cavity (141) and a second dielectric layer (172; 372) provided above the first cavity (141), and
wherein the second unit filter (121; 221) further comprises a third dielectric layer (181; 381) provided below the second cavity (161) and a fourth dielectric layer (182; 382) provided above the second cavity (161).

8. An electronic device comprising the image sensor (1000) of claim 6,
wherein the electronic device is one of a mobile phone, a smartphone, a tablet, a smart tablet, a digital camera, a camcorder, a notebook computer, a television, a smart television, a smart refrigerator, a security camera, a robot, or a medical camera.

9. The spectral filter (1100; 1200; 1300) according to claim 1,
wherein the second filter array (120; 220; 320) is provided adjacent to the first filter array (110; 210; 310) in a horizontal direction,
wherein the two first metal reflective layers (131, 132) in the first filter array (110; 210; 310) are provided offset from the two second metal reflective layers (151, 152) in the second filter array (120; 220; 320) in a vertical direction.

## Patentansprüche

1. Ein Spektralfilter (1100; 1200; 1300), umfassend:
einen ersten Einheitsfilter (111; 211) mit einer ersten Zentralwellenlänge in einem ersten Wellenlängenbereich; und
einen zweiten Einheitsfilter (121; 221) mit einer zweiten Zentralwellenlänge in einem zweiten Wellenlängenbereich,
wobei der erste Einheitsfilter (111; 211) umfasst:
zwei erste Metallreflexionsschichten (131, 132), die voneinander beabstandet vorgesehen sind und ein erstes Metall umfassen; und
einen ersten Hohlraum (141), der zwischen den zwei ersten Metallreflexionsschichten (131, 132) vorgesehen ist, und
wobei der zweite Einheitsfilter (121; 221) umfasst:
zwei zweite Metallreflexionsschichten (151, 152), die voneinander beabstandet sind und ein zweites Metall umfassen, das sich vom ersten Metall unterscheidet; und
einen zweiten Hohlraum (161), der zwischen den zwei zweiten Metallreflexionsschichten (151, 152) vorgesehen ist,
wobei der erste Einheitsfilter (111; 211) und der zweite Einheitsfilter (121; 221) in einer Dimension oder zwei Dimensionen auf einer Ebene vorgesehen sind;
**der Spektralfilter (1100; 1200; 1300) dadurch gekennzeichnet ist, dass**
der erste Einheitsfilter (111; 211) in einer ersten Filteranordnung (110; 210; 310) enthalten ist, die eine Vielzahl von ersten Einheitsfiltern (111-113; 211-213; 315) mit unterschiedlichen Zentralwellenlängen im ersten Wellenlängenbereich umfasst, und der zweite Einheitsfilter (121; 221) in einer zweiten Filteranordnung (120; 220; 320) enthalten ist, die eine Vielzahl von zweiten Einheitsfiltern (121-123; 221-223; 325) mit unterschiedlichen Zentralwellenlängen im zweiten Wellenlängenbereich umfasst,
wobei jeder der in der ersten Filteranordnung (110; 210; 310) enthaltenen ersten Einheitsfilter (111-113; 211-213; 315) und jeder der in der zweiten Filteranordnung (120; 220; 320) enthaltenen zweiten Einheitsfilter (121-123; 221-223; 325) 20) einen Hohlraum (141-143, 161-161; 145, 165) umfassen und die Hohlräume (141-143, 161-161; 145, 165) unterschiedliche Dicken oder effektive Indizes aufweisen, die Dicke oder der effektive Index der Hohlräume (141-143, 161 -161; 145, 165) insbesondere in Bezug auf jede der ersten Filteranordnung (110; 210; 310) und der zweiten Filteranordnung (120; 220; 320) anschließend erhöht wird.

2. Der Spektralfilter (1100; 1200; 1300) nach Anspruch 1, wobei die erste Zentralwellenlänge im ersten Wellenlängenbereich kürzer ist als die zweite Zentralwellenlänge im zweiten Wellenlängenbereich,
wobei die erste Zentralwellenlänge des ersten Einheitsfilters (111; 211) so konfiguriert ist, dass sie auf Grundlage einer Änderung der Dicke oder eines effektiven Brechungsindex des ersten Hohlraums (141) angepasst werden kann, und
wobei die zweite Zentralwellenlänge des zweiten Einheitsfilters (121; 221) so konfiguriert ist, dass sie auf Grundlage einer Änderung der Dicke oder eines effektiven Brechungsindex des zweiten Hohlraums (161) angepasst werden kann.

3. Der Spektralfilter (1100; 1200; 1300) nach Anspruch 2, wobei die zwei ersten Metallreflexionsschichten (131, 132) eines von Aluminium (Al), Silber (Ag), Gold (Au) oder Titannitrid (TiN) umfassen, und
wobei die zwei zweiten Metallreflexionsschichten (151, 152) eines von Kupfer (Cu), Ag, Au oder TiN umfassen, das sich von den zwei ersten Metallreflexionsschichten (131, 132) unterscheidet.

4. Der Spektralfilter (1100; 1200; 1300) nach einem der Ansprüche 1 bis 3, wobei der erste Einheitsfilter (111; 211) ferner eine erste dielektrische Schicht (171; 371), die unter dem ersten Hohlraum (141) vorgesehen ist, und eine zweite dielektrische Schicht (172; 372), die über dem ersten Hohlraum (141) vorgesehen ist, umfasst,
wobei der zweite Einheitsfilter (121; 221) ferner eine dritte dielektrische Schicht (181; 381), die unter dem zweiten Hohlraum (161) vorgesehen ist, und eine vierte dielektrische Schicht (182; 382), die über dem zweiten Hohlraum (161) vorgesehen ist, umfasst,
wobei jede der ersten dielektrischen Schicht (171; 371), der zweiten dielektrischen Schicht (172; 372), der dritten dielektrischen Schicht (181; 381) und der vierten dielektrischen Schicht (182; 382) eine einzelne Schicht oder mehrere Schichten umfasst, und
wobei jede der ersten dielektrischen Schicht (171; 371), der zweiten dielektrischen Schicht (171; 372), der dritten dielektrischen Schicht (181; 381) und der vierten dielektrischen Schicht (182; 382) eine Dicke im Bereich von 10 nm bis 20000 nm aufweist.

5. Der Spektralfilter (1100; 1200; 1300) nach Anspruch 4, wobei mindestens eine der Dicken oder ein effektiver Brechungsindex von jeder der ersten dielektrischen Schicht (171; 371) und der zweiten dielektrischen Schicht (172; 372) basierend auf der ersten Zentralwellenlänge des ersten Einheitsfilters (111; 211) angepasst wird, und
wobei eine Dicke oder ein effektiver Brechungsindex von jeder der dritten dielektrischen Schicht (181; 381) und der vierten dielektrischen Schicht (182; 382) basierend auf der zweiten Zentralwellenlänge des zweiten Einheitsfilters (121; 221) angepasst wird.

6. Ein Bildsensor (1000), umfassend:
den Spektralfilter (1100; 1200; 1300) gemäß Anspruch 1; und
ein Pixelarray (4100), so konfiguriert, dass es durch den Spektralfilter (1100; 1200; 1300) durchgelassenes Licht empfängt.

7. Der Bildsensor (1000) nach Anspruch 6, wobei der erste Einheitsfilter (111; 211) ferner eine erste dielektrische Schicht (171; 371), die unter dem ersten Hohlraum (141) vorgesehen ist, und eine zweite dielektrische Schicht (172; 372), die über dem ersten Hohlraum (141) vorgesehen ist, umfasst, und
wobei der zweite Einheitsfilter (121; 221) ferner eine dritte dielektrische Schicht (181; 381), die unter dem zweiten Hohlraum (161) vorgesehen ist, und eine vierte dielektrische Schicht (182; 382), die über dem zweiten Hohlraum (161) vorgesehen ist, umfasst.

8. Ein elektronisches Gerät, das den Bildsensor (1000) von Anspruch 6 umfasst,
wobei das elektronische Gerät eines aus einem Mobiltelefon, einem Smartphone, einem Tablet, einem Smart-Tablet, einer Digitalkamera, einem Camcorder, einem Notebook, einem Fernseher, einem Smart-Fernseher, einem Smart-Kühlschrank, einer Sicherheitskamera, einem Roboter oder einer medizinischen Kamera ist.

9. Der Spektralfilter (1100; 1200; 1300) nach Anspruch 1,
wobei die zweite Filteranordnung (120; 220; 320) in horizontaler Richtung neben der ersten Filteranordnung (110; 210; 310) angeordnet ist,
wobei die beiden ersten Metallreflexionsschichten (131, 132) in der ersten Filteranordnung (110; 210; 310) in vertikaler Richtung versetzt von den beiden zweiten Metallreflexionsschichten (151, 152) in der zweiten Filteranordnung (120; 220; 320) vorgesehen sind.

## Revendications

1. Filtre spectral (1100 ; 1200 ; 1300) comprenant :
un premier filtre unitaire (111 ; 211) ayant une première longueur d'onde centrale dans une première plage de longueur d'onde ; et
un second filtre unitaire (121 ; 221) ayant une seconde longueur d'onde centrale dans une seconde plage de longueur d'onde,
dans lequel le premier filtre unitaire (111 ; 211) comprend :
deux premières couches réfléchissantes métalliques (131, 132) disposées espacées l'une de l'autre et comprenant un premier métal ; et
une première cavité (141) disposée entre les deux premières couches réfléchissantes métalliques (131, 132), et
dans lequel le second filtre unitaire (121 ; 221) comprend :
deux secondes couches réfléchissantes métalliques (151, 152) disposées espacées l'une de l'autre et comprenant un second métal différent du premier métal ; et
une seconde cavité (161) disposée entre les deux secondes couches réfléchissantes métalliques (151, 152),
dans lequel le premier filtre unitaire (111 ; 211) et le second filtre unitaire (121 ; 221) sont disposés dans une dimension ou deux dimensions sur un plan ;
le filtre spectral (1100 ; 1200 ; 1300) étant **caractérisé en ce que**
le premier filtre unitaire (111 ; 211) est intégré dans un premier réseau de filtres (110 ; 210 ; 310) comprenant une pluralité de premiers filtres unitaires (111-113 ; 211-213 ; 315) ayant des longueurs d'onde centrales différentes dans la première plage de longueur d'onde, et
le second filtre unitaire (121 ; 221) est intégré dans un second réseau de filtres (120 ; 220 ; 320) comprenant une pluralité de seconds filtres unitaires (121-123 ; 221-223 ; 325) ayant des longueurs d'onde centrales différentes dans la seconde plage de longueur d'onde,
dans lequel chacun des premiers filtres unitaires (111-113 ; 211-213 ; 315) intégrés dans le premier réseau de filtres (110 ; 210 ; 310) et chacun des seconds filtres unitaires (121-123 ; 221-223 ; 325) intégrés dans le second réseau de filtres (120 ; 220 ; 320) comprennent une cavité (141-143, 161-161 ; 145, 165) et les cavités (141-143, 161-161 ; 145, 165) ont des épaisseurs ou des indices effectifs différents, en particulier, l'épaisseur ou l'indice effectif des cavités (141-143, 161-161 ; 145, 165) concernant chacun du premier réseau de filtres (110 ; 210 ; 310) et du second réseau de filtres (120 ; 220 ; 320) est ensuite augmenté.

2. Filtre spectral (1100 ; 1200 ; 1300) selon la revendication 1, dans lequel la première longueur d'onde centrale dans la première plage de longueur d'onde est plus courte que la seconde longueur d'onde centrale dans la seconde plage de longueur d'onde, dans lequel la première longueur d'onde centrale du premier filtre unitaire (111 ; 211) est configurée pour être ajustée sur la base d'un changement de l'épaisseur ou d'un indice de réfraction effectif de la première cavité (141), et
dans lequel la seconde longueur d'onde centrale du second filtre unitaire (121 ; 221) est configurée pour être ajustée sur la base d'un changement de l'épaisseur ou d'un indice de réfraction effectif de la seconde cavité (161).

3. Filtre spectral (1100 ; 1200 ; 1300) selon la revendication 2, dans lequel les deux premières couches réfléchissantes métalliques (131, 132) comprennent l'un parmi de l'aluminium (AI), argent (Ag), or (Au), ou nitrure de titane (TiN), et
dans lequel les deux secondes couches réfléchissantes métalliques (151, 152) comprennent l'un parmi du cuivre (Cu), Ag, Au, ou TiN qui est différent des deux premières couches réfléchissantes métalliques (131, 132).

4. Filtre spectral (1100 ; 1200 ; 1300) selon l'une des revendications 1 à 3, dans lequel le premier filtre unitaire (111 ; 211) comprend en outre une première couche diélectrique (171 ; 371) qui est disposée sous la première cavité (141) et une deuxième couche diélectrique (172 ; 372) disposée au-dessus de la première cavité (141),
dans lequel le second filtre unitaire (121 ; 221) comprend en outre une troisième couche diélectrique (181 ; 381) disposée sous la seconde cavité (161) et une quatrième couche diélectrique (182 ; 382) disposée au-dessus de la seconde cavité (161),
dans lequel chacune de la première couche diélectrique (171 ; 371), de la deuxième couche diélectrique (172 ; 372), de la troisième couche diélectrique (181 ; 381), et de la quatrième couche diélectrique (182 ; 382) comprend une couche unique ou de multiples couches, et
dans lequel chacune de la première couche diélectrique (171 ; 371), de la deuxième couche diélectrique (171 ; 372), de la troisième couche diélectrique (181 ; 381), et de la quatrième couche diélectrique (182 ; 382) a une épaisseur dans la plage de 10 nm à 20 000 nm.

5. Filtre spectral (1100 ; 1200 ; 1300) selon la revendication 4, dans lequel au moins l'un d'une épaisseur ou d'un indice de réfraction effectif de chacune de la première couche diélectrique (171 ; 371) et de la deuxième couche diélectrique (172 ; 372) est ajusté sur la base de la première longueur d'onde centrale du premier filtre unitaire (111 ; 211), et
dans lequel une épaisseur ou un indice de réfraction effectif de chacune de la troisième couche diélectrique (181 ; 381) et de la quatrième couche diélectrique (182 ; 382) est ajusté sur la base de la seconde longueur d'onde centrale du second filtre unitaire (121 ; 221).

6. Capteur d'image (1000) comprenant :
le filtre spectral (1100 ; 1200 ; 1300) selon la revendication 1 ; et
un réseau de pixels (4100) configuré pour recevoir de la lumière transmise à travers le filtre spectral (1100 ; 1200 ; 1300).

7. Capteur d'image (1000) selon la revendication 6, dans lequel le premier filtre unitaire (111 ; 211) comprend en outre une première couche diélectrique (171 ; 371) disposée sous la première cavité (141) et une deuxième couche diélectrique (172 ; 372) disposée au-dessus de la première cavité (141), et
dans lequel le second filtre unitaire (121 ; 221) comprend en outre une troisième couche diélectrique (181 ; 381) disposée sous la seconde cavité (161) et une quatrième couche diélectrique (182 ; 382) disposée au-dessus de la seconde cavité (161).

8. Dispositif électronique comprenant le capteur d'image (1000) selon la revendication 6,
dans lequel le dispositif électronique est l'un parmi un téléphone mobile, un smartphone, une tablette, une tablette intelligente, un appareil photo numérique, une caméra vidéo, un ordinateur portable, un téléviseur, un téléviseur intelligent, un réfrigérateur intelligent, une caméra de sécurité, un robot, ou une caméra médicale.

9. Filtre spectral (1100 ; 1200 ; 1300) selon la revendication 1,
dans lequel le second réseau de filtres (120 ; 220 ; 320) est disposé de manière adjacente au premier réseau de filtres (110 ; 210 ; 310) dans une direction horizontale, dans lequel les deux premières couches réfléchissantes métalliques (131, 132) dans le premier réseau de filtres (110 ; 210 ; 310) sont disposées décalées par rapport aux deux secondes couches réfléchissantes métalliques (151, 152) dans le second réseau de filtres (120 ; 220 ; 320) dans une direction verticale.
